(19) Europäisches Patentamt
European Patent Office
Office européen des brevets

(11) EP 1 860 152 B1

(12) **EUROPEAN PATENT SPECIFICATION**

(45) Date of publication and mention of the grant of the patent:
**25.11.2009 Bulletin 2009/48**

(21) Application number: **06712703.5**

(22) Date of filing: **31.01.2006**

(51) Int Cl.:
***C08L 45/00*** *(2006.01)* ***C08K 3/00*** *(2006.01)*
***C08L 9/00*** *(2006.01)* ***C08L 23/00*** *(2006.01)*
***C08L 23/26*** *(2006.01)* ***C08L 25/02*** *(2006.01)*
***C08L 65/00*** *(2006.01)* ***H05K 1/03*** *(2006.01)*

(86) International application number:
**PCT/JP2006/301560**

(87) International publication number:
**WO 2006/095511 (14.09.2006 Gazette 2006/37)**

(54) **CYCLIC OLEFIN RESIN COMPOSITION, AND SUBSTRATE PROVIDED FROM SAID RESIN COMPOSITION**

CYCLOOLEFINHARZZUSAMMENSETZUNG UND DARAUS BEREITGESTELLTES SUBSTRAT

COMPOSITION DE RÉSINE D'UNE OLÉFINE CYCLIQUE ET SUBSTRAT FORMÉ À PARTIR DE LADITE COMPOSITION DE RÉSINE

(84) Designated Contracting States:
**DE FR GB IT**

(30) Priority: **07.03.2005 JP 2005062652**

(43) Date of publication of application:
**28.11.2007 Bulletin 2007/48**

(73) Proprietor: **Mitsui Chemicals, Inc.**
**Tokyo 105-7117 (JP)**

(72) Inventors:
- **KANEKO, Kazuyoshi**
  **aura-shi, Chiba, 2990265 (JP)**
- **HIROSE, Toshiyuki**
  **aura-shi, Chiba, 2990265 (JP)**
- **YAMAOKA, Hiroyasu**
  **aura-shi, Chiba, 2990265 (JP)**
- **GOTO, Kenichi**
  **aura-shi, Chiba, 2990265 (JP)**
- **HASEGAWA, Akira**
  **aura-shi, Chiba, 2990265 (JP)**

(74) Representative: **Cresswell, Thomas Anthony et al**
**J.A. KEMP & CO.**
**14 South Square**
**Gray's Inn**
**London**
**WC1R 5JJ (GB)**

(56) References cited:
**EP-A- 0 361 909** **EP-A- 1 790 690**
**EP-A- 1 790 691** **JP-A- 2000 038 414**
**JP-A- 2002 201 338** **JP-A- 2003 238 761**
**JP-A- 2005 047 991** **JP-A- 2005 255 917**
**US-B1- 6 331 591**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 860 152 B1

## Description

### TECHNICAL FIELD

The present invention relates to a cyclic olefin resin composition which is suitable as a material for a substrate having excellent dielectric properties, low water absorbability, excellent heat resistance and the like, particularly which is suitable as a material for a substrate for high frequency circuit, and a substrate obtained from the resin composition.

### BACKGROUND ART

In recent years, there is a demand in the field of information and communication instruments, for higher capacity for information transmission and higher frequency for high speed processing. Heretofore, signals at high frequencies over 1 GHz (gigahertz) have been used for limited uses such as radar, satellite communications and the like, but such signals are recently used in highly familiar uses such as mobile phones, wireless LAN and the like. Furthermore, as high speed and high functionality of computers or communication instruments are being achieved, the signals used in information transmission between these instruments are also rapidly being changed to high frequency signals. In the related art, epoxy resins or phenolic resins have been mainly used as the material for printed circuit boards. However, these resins cannot be used for high frequency circuits because they exhibit poor dielectric properties in the region of higher frequencies, large transmission losses, and the like.

In addition, although inorganic substrate materials such as ceramics, alumina and the like generally have low dielectric tangent. However, replacement from the inorganic materials to organic materials is in progress, from the viewpoints of handlability, availability, costs and the like. This phenomenon has led to a strong demand for the development of a material for a substrate which can be used in the GHz frequency region and has excellent electric properties (high frequency transmission properties, low dielectric properties), and thus polyphenylene ether resins, bismaleimidetriazine resins and the like have been developed and put to practical use (see Non-Patent Document 1 and Patent Document 1). However, the signal frequencies now far exceed the range of several gigahertz, reaching to the range of several tens of gigahertz, and therefore this increase in the frequency of signals is approaching a region where even these new materials cannot deal with.

Meanwhile, polyolefins such as polyethylene, polypropylene and the like are excellent in dielectric properties such as permittivity, dielectric tangent and the like, but these materials by themselves have poor heat resistance. Thus, the materials cannot withstand the processes for manufacturing electric circuits, including soldering and the like, which require temperature conditions exceeding 200°C. In order to improve this problem, a material having improved heat resistance while maintaining excellent dielectric properties has been developed, by copolymerizing cyclic olefins (see Patent Document 2). However, for the reasons that the soldering temperature has recently been further raised due to the regulations for lead-free soldering, and for other reasons, heat resistance up to a temperature of 260°C or above is desired.

Polyimide resins which have excellent heat resistance and have resistance even to the soldering temperatures achieved by lead-free soldering are also used as a substrate material. However, since polyimide resins have a relatively high water absorption rate, a substrate containing polyimidoresins sometimes exhibit delamination or microcracks, due to the pressure of the moisture contained in the substrate, which is in turn caused by heating associated with solder reflow or the like. Therefore, there is a need for heat resistance to a temperature of 260°C or above, as well as low water absorbability.

Furthermore, it is usual for fluorinated materials or olefinic materials, which have poor adhesiveness to metal, to maintain the adhesiveness by means of an anchoring effect (wedge); by increasing the roughness of the metal surface. However, since a high frequency current has a property called skin effect in which the current tends to flow only through the superficial stratum of a metal conductor, when the surface roughness increases, the electric resistance also increases to cause deterioration of signal propagation. In association with the increase in signal frequency, since metal conductors with smooth surfaces now need to be used, these materials cannot be used as high frequency materials even though they have high dielectric properties. As a method of improving adhesiveness, a method is disclosed to use a layer of reinforced plastic prepared by impregnating reinforcing fibers with a resin comprising poly-4-methyl-1-pentene graft-modified with unsaturated carboxylic acid or a derivative thereof (see Patent Document 3). However, in this technology, the surface of the resin layer in contact with a conductor is made of poly-4-methyl-1-pentene having a melting point of 235°C, and thus does not have sufficient heat resistance to cope with lead-free soldering.

Under such circumstances, development of a cyclic olefin resin composition which is suitable as a material for a substrate having excellent dielectric properties, low water absorbability, heat resistance and the like, and particularly as a material for a substrate for high frequency circuit, and development of a substrate provided therefrom have been so much anticipated.

[Non-Patent Document 1] Polymeric Materials for High Frequency Applications, CMC Publishing, Inc. (1999)
[Patent Document 1] Japanese Laid-Open Patent Application Publication No. 50-132099
[Patent Document 2] Japanese Laid-Open Patent Application Publication No. 62-29191
[Patent Document 3] Japanese Laid-Open Patent Application Publication No. 1-81390

DISCLOSURE OF THE INVENTION

The present invention is intended to solve the problems associated with related art as described above, and it is an object of the invention to provide a cyclic olefin resin composition which can be suitably used as a material for a substrate having excellent dielectric properties, low water absorbability, heat resistance and the like, and a substrate obtained from the resin composition. In particular, the object of the invention is to provide a novel cyclic olefin resin composition which can be suitably used as a material for a substrate for high frequency circuit dealing with high frequency signal transmission, and a substrate obtained from the resin composition.

The present invention provides a cyclic olefin resin composition as described in the following [1] to [8], a substrate as described in the following [9] to [10], and a use as described in [11].

[1]

A cyclic olefin resin composition comprising:

(A) 35 to 85 parts by weight of a cyclic olefin polymer having a glass transition temperature of 60 to 200°C;
(B) 10 to 60 parts by weight of a flexible copolymer produced by polymerizing at least two or more monomers selected from the group consisting of an olefin compound, a diene compound and an aromatic vinyl hydrocarbon compound, and having a glass transition temperature of 0°C or lower; and
(C) 5 to 55 parts by weight of a modified polyolefin which is a polyolefin having a polar group; and further comprising, based on 100 parts by weight of the components (A), (B) and (C):
(D) 0.01 to 5 parts by weight of a radical initiator; and
(E) 0 to 5 parts by weight of a polyfunctional compound having two or more radical polymerizable functional groups in the molecule.

[2]

The cyclic olefin resin composition described in [1] above, wherein the radical initiator (D) is an organic peroxide.

[3]

The cyclic olefin resin composition described in [1] above, wherein
the cyclic olefin polymer (A) is a cyclic olefin polymer having one or two or more structures represented by the following General Formula (1):

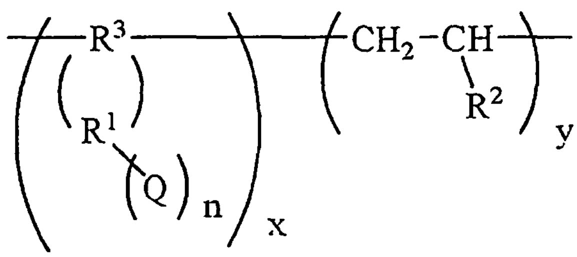

(1)

wherein x and y represent copolymerization ratios, and are real numbers satisfying the relationship: $0/100 \leq y/x \leq 95/5$, while x and y are on the molar basis;
n represents the number of substitution for substituent Q, and is an integer of $0 \leq n \leq 2$;
$R^1$ is a group having a valence of (2+n), selected from the group consisting of hydrocarbon groups having 2 to 20 carbon atoms, while $R^1$, which is present in plurality, may be identical or different;
$R^2$ is a hydrogen atom, or a monovalent group selected from the group consisting of hydrocarbon groups which are composed of carbon and hydrogen, and have 1 to 10 carbon atoms, while $R^2$ , which is present in plurality, may be

identical or different;
$R^3$ is a tetravalent group selected from the group consisting of hydrocarbon groups having 2 to 10 carbon atoms, while $R^3$, which is present in plurality, may be identical or different; and
Q represents $COOR^4$ (wherein $R^4$ is a hydrogen atom or a monovalent group selected from the group consisting of hydrocarbon groups which are composed of carbon and hydrogen, and have 1 to 10 carbon atoms), while Q, which is present in plurality, may be identical or different.

[4]

The cyclic olefin resin composition described in [1] above, wherein the cyclic olefin polymer (A) is a ring-opening polymer of a cyclic olefin, or a hydrogenation product thereof.

[5]

The cyclic olefin resin composition described in [1] above, wherein the cyclic olefin polymer (A) is a cyclic olefin polymer having one or two or more structures represented by the following General Formula (2):

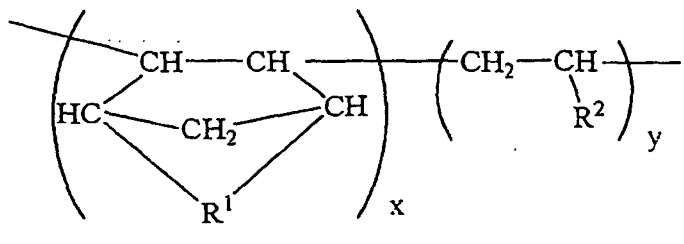

(2)

wherein $R^1$ is a group having a valence of (2+n) selected from the group consisting of hydrocarbon groups having 2 to 20 carbon atoms, while $R^1$, which is present in plurality, may be identical or different;
$R^2$ is hydrogen, or a monovalent group selected from the group consisting of hydrocarbon groups having 1 to 5 carbon atoms, while $R^2$, which is present in plurality, may be identical or different; and
x and y represent copolymerization ratios, and are real numbers satisfying the relationship: $5/95 \leq y/x \leq 95/5$, while x and y are on the molar basis.

[6]

The cyclic olefin resin composition described in [1] above, wherein the cyclic olefin polymer (A) is a copolymer of ethylene and tetracyclo [ 4 . 4 . 0 . $1^{2,5}$ . $1^{7,10}$] -3-dodecene .

[7]

The cyclic olefin resin composition described in [1] above, wherein the composition is obtained by reacting the components (D) and (E) with the components (A), (B) and (C).

[8]

The cyclic olefin resin composition described in [1] above, wherein the composition further comprises (F) 0 to 600 parts by weight of an inorganic filler based on 100 parts by weight of the total amount of the components (A), (B), (C), (D) and (E).

[9]

A substrate for a printed circuit board obtainable by molding the cyclic olefin resin composition described in any one of [1] to [8] above.

[10]

A substrate for high frequency circuit, formed from the substrate described in [9] above.

[11] Use of a substrate described in [10] above as a substrate for a high frequency circuit. The cyclic olefin resin composition of the invention allows that a substrate having excellent dielectric properties, low water absorbability, heat resistance and the like is provided. This substrate has particularly excellent dielectric properties in the high frequency region, and can be suitably used as a substrate for high frequency circuit.

BEST MODE FOR CARRYING OUT THE INVENTION

The cyclic olefin resin composition of the present invention comprises:

(A) 35 to 85 parts by weight of a cyclic olefin polymer;
(B) 10 to 60 parts by weight of a flexible copolymer; and
(C) 5 to 55 parts by weight of a modified polyolefin which is a polyolefin having a polar group; and further comprises, based on 100 parts by weight of the sum of the components (A), (B) and (C):
(D) 0.01 to 5 parts by weight of a radical initiator; and
(E) 0 to 5 parts by weight of a polyfunctional compound.

Using such cyclic olefin resin composition, a substrate having excellent dielectric properties, low absorbability, excellent heat resistance and the like can be provided. This substrate is particularly excellent in the dielectric properties in the high frequency region, and can be suitably used as a substrate for high frequency circuit. As such, the cyclic olefin resin composition of the invention can be suitably used for substrate forming applications.
Moreover, since the cyclic olefin resin composition of the present invention contains a modified polyolefin (C), the substrate obtained from the composition has excellent adhesiveness to electroconductive materials such as metal foil and the like.
Meanwhile, the adhesiveness to electroconductive materials such as copper foil and the like can also be improved by modifying a cyclic olefin polymer with maleic anhydride or the like. However, it requires a large amount of modification so as to obtain a predetermined adhesive strength. When a film or the like is molded from a resin composition containing such modified cyclic olefin polymer, there are problems such as yellowing of the film, lowered heat resistance, and the like.
On the other hand, a resin composition containing a cyclic olefin polymer and a modified polyolefin, such as the cyclic olefin resin composition of the present invention, does not cause yellowing of a film which is obtained by molding the resin composition, and is also excellent in heat resistance. Furthermore, the adhesiveness to electroconductive materials can also be improved.
Hereinafter, the respective components used in the cyclic olefin resin composition of the present embodiment will be described.

<Cyclic olefin polymer (A)>

The cyclic olefin polymer (A) is not particularly limited as long as it has a glass transition temperature as described below, but specifically, a cyclic olefin polymer having one or two or more structures represented by the following General Formula (1):

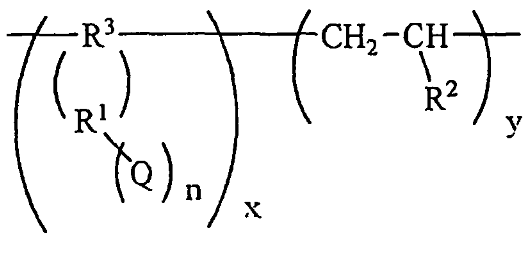

(1)

wherein x and y represent copolymerization ratios, and are real numbers satisfying the relationship: 0/100 5 y/x ≤ 95/5, while x and y are on the molar basis;
n represents the number of substitution for substituent Q, and is an integer of 0 ≤ n ≤ 2;
$R^1$ is a group having a valence of (2+n) selected from the group consisting of hydrocarbon groups having 2 to 20 carbon atoms, while $R^1$ present in plurality may be identical or different;

$R^2$ is a hydrogen atom, or a monovalent group selected from the group consisting of hydrocarbon groups which are composed of carbon and hydrogen, and have 1 to 10 carbon atoms, while $R^2$ present in plurality may be identical or different;
$R^3$ is a tetravalent group selected from the group consisting of hydrocarbon groups having 2 to 10 carbon atoms, while $R^3$ present in plurality may be identical or different; and
Q represents $COOR^4$ (wherein $R^Q$ is a hydrogen atom, or a monovalent group selected from the group consisting of hydrocarbon groups which are composed of carbon and hydrogen, and have 1 to 10 carbon atoms), while Q present in plurality may be identical or different.
For the respective symbols, the following preferred conditions may be mentioned, and these conditions are used in combinations as necessary.

[1] $R^1$ is a group having a cyclic structure on at least one site in the structure.
[2] $R^3$ is an exemplary structural unit containing this $R^1$ (in the case of n = 0), and is an exemplary structure (a), (b) or (c):

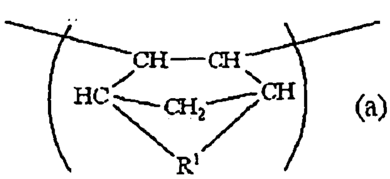 (a) 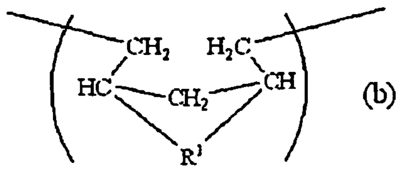 (b) 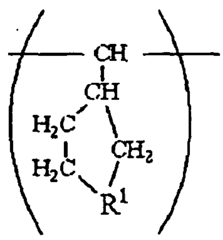 (c)

wherein $R^1$ is a group having a valence of (2+n) selected from the group consisting of hydrocarbon groups having 2 to 20 carbon atoms.
[3] n is 0.
[4] y/x is a real number satisfying the relationships: $5/95 \leq y/x \leq 95/5$, and more preferably $20/80 \leq y/x \leq 65/35$, on the molar basis, respectively.
[5] $R^2$ is a hydrogen atom or $-CH_3$, and $R^2$, which is present in plurality, may be identical or different.
[6] Q is a $-COOH$ or $-COOCH_3$ group.

The cyclic olefin polymer (A) preferably has one or two or more structures represented by the following General Formula (2), and the preferred conditions as described above are used in combination as necessary.

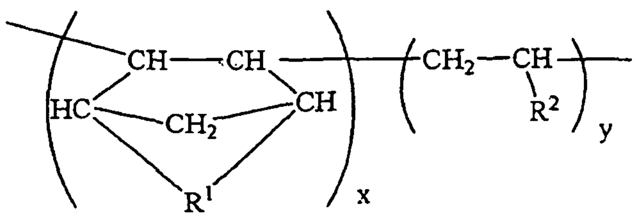

(2)

For the respective symbols in the General Formula (2), the following preferred conditions may be further mentioned, and these conditions are used in combinations as necessary.

[1] Group $R^1$ is a divalent group represented by General Formula (3):

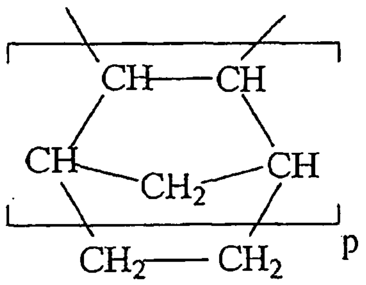

(3)

wherein p is an integer from 0 to 2. More preferably, $R^1$ is a divalent group, with p being 1, in the General Formula (3).
[2] $R^2$ is a hydrogen atom.

Among these, as an embodiment of combinations thereof, it is preferable that the cyclic olefin polymer is a polymer obtained by random addition polymerization of ethylene and tetracyclo [ 4 . 4 . 0 . $1^{2,5}$. $1^{7,10}$]-3-dodecene (hereinafter, abbreviated to TD).

In the case where the cyclic olefin polymer (A) is a ring-opening polymer of a cyclic olefin, the following preferred conditions may be mentioned for the respective symbols in the General Formula (1), and these conditions are used in combination as necessary.

(11 $R^1$ is a group having a cyclic structure on at least one site in the structure.
[2] $R^3$ is an exemplary structural unit containing this $R^1$ (in the case where n = 0), and includes at least the exemplary structure (b) shown above.
[3] n is 0.
[4] y/x is a real number satisfying the relationship: $0/100 \leq y/x \leq 80/20$, and more preferably $0/100 \leq y/x \leq 50/50$, on the molar basis, respectively.
[5] $R^2$ is a hydrogen atom or $-CH_3$, and $R^2$, which is present in plurality, may be identical or different.
[6] Q represents $COOR^4$ (wherein $R^9$ is a hydrogen atom, or a monovalent group selected from the group consisting of hydrocarbon groups which are composed of carbon and hydrogen, and have 1 to 10 carbon atoms), and Q, which is present in plurality, may be identical or different.

The ring-opening polymer of a cyclic olefin, which is the cyclic olefin polymer (A), preferably comprises one or two or more structures represented by the following General Formula (4), and preferred conditions as described above are used in combination as necessary.

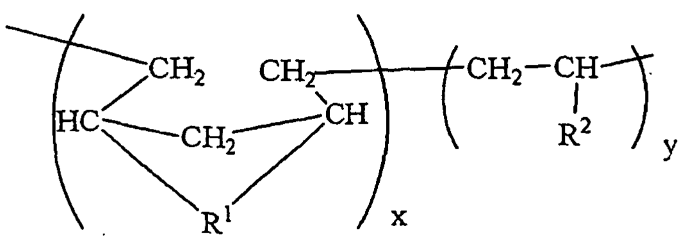

(4)

Moreover, in the case of binding the monomer-derived constituent units which are repeated x times, these constituent units are bound via double bonds.

The following most preferred conditions may be further mentioned for the respective symbols in the General Formula (4), and these conditions are used in combination as necessary.

[1] Group $R^1$ is any of the following examples.
[2] Group $R^2$ is a hydrogen atom.

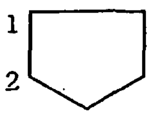
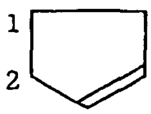
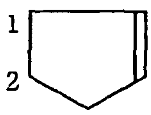
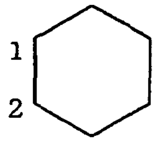
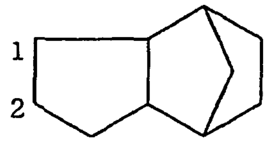

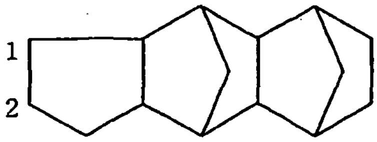
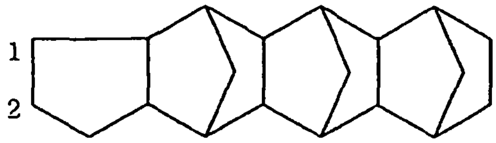

Furthermore, with regard to these examples, the carbon atoms assigned with number 1 or 2 represent the carbon atoms which are bound to the carbon atoms in General Formula (4). Also, these exemplary structures may have an alkylidene group in part of the structures. This alkylidene group is usually an alkylidene group having 2 to 20 carbon atoms, and specific examples of such alkylidene group include an ethylidene group, a propylidene group and an isopropylidene group.

Among these, as an embodiment of combinations thereof, it is preferable that the ring-opening polymer of a cyclic olefin is a polymer obtained by ring-opening polymerization of tricyclo[4.3.0.$1^{2,5}$]deca-3,7-diene (dicyclopentadiene: DCPD) .

When the cyclic olefin polymer (A) is a hydrogenation product of the ring-opening polymer of a cyclic olefin, the hydrogenation product is obtained by saturating part or all of the double bonds in the ring-opening polymer.

According to the invention, as the cyclic olefin resin composition contains a ring-opening polymer of a cyclic olefin or a hydrogenation product thereof as the cyclic olefin polymer (A), the substrate resulting from the cyclic olefin resin composition has excellent toughness as compared to the case of the composition containing copolymer of a cyclic olefin. For this reason, the substrate can be used as a printed circuit board or a package board, and can be suitably used as a substrate for high frequency circuit, among flexible substrates.

(Type of polymerization)

The type of polymerization for the cyclic olefin polymer is not at all limited for the invention, and various known types of polymerization, such as random copolymerization, block copolymerization, alternating copolymerization, ring-opening polymerization and the like, can be applied.

(Other structures that can be used as part of main chain)

The cyclic olefin polymer used in the invention may have, if necessary, repeating structural units derived other copolymerizable monomers, within the scope of not impairing the good properties of the substrate obtained from the resin composition of the invention. The copolymerization ratio is not limited, but it is preferably 20% by mole or less, and more preferably 10% by mole or less. If the ratio is less than or equal to the value, a substrate having excellent heat resistance can be obtained, without impairing heat resistance. Furthermore, the type of copolymerization is not limited, but a random copolymer is desired.

(Molecular weight of polymer)

The molecular weight of the cyclic olefin polymer is not limited, but in the case of using the intrinsic viscosity [n] as an alternative indicator of the molecular weight, the intrinsic viscosity [n] as measured in decalin at 135°C is 0.03 to 10 dl/g, more preferably 0.05 to 5 dl/g, and most preferably 0.10 to 2 dl/g.

If the intrinsic viscosity is higher than this range, moldability is deteriorated. If the intrinsic viscosity is lower than this range, the molded product becomes brittle. That is, if the intrinsic viscosity is within the above-described range, the resulting polymer is excellently balanced in these properties.

(Glass transition temperature)

Cyclic olefin polymers having a glass transition temperature in the range of 60°C to 200°C are used. Among these, those having a glass transition temperature in the range of 100°C to 200°C are preferred. If the glass transition

temperature is not lower than the lower limit value, there can be provided a substrate having excellent reliability even under the circumstance that the use environment for the product (substrate) is at a high temperature. If the glass transition temperature is not higher than the upper limit value, the polymer attains excellent melt moldability. That is, when a cyclic olefin polymer having a glass transition temperature in the above-mentioned range is used, the polymer is excellently balanced in these properties.

(Process for producing cyclic olefin polymer (A))

The method for producing the cyclic olefin polymer (A) will be explained with reference to the methods for producing a random copolymer, a ring-opening polymer, and a hydrogenation product of the ring-opening polymer.

(Process for producing random copolymer)

In the case where the cyclic olefin polymer is a random copolymer of ethylene and a cyclic olefin, the cyclic olefin polymer can be produced by the production method disclosed in JAPANESE LAID-OPEN PATENT APPLICATION PUBLICATION No. 7-145213, using ethylene and a cyclic olefin represented by Formula [I] . In particular, it is preferable to perform this copolymerization in a hydrocarbon solvent, and produce a random copolymer of ethylene and the cyclic olefin using a catalyst formed from a vanadium compound and an organic aluminum compound which are soluble in the hydrocarbon solvent.

Furthermore, in this copolymerization reaction, a solid state Group 4 metallocene catalyst may be used. Here, the solid state Group 4 metallocene catalyst is a catalyst comprising a transition metal compound containing a ligand having a cyclopentadienyl skeleton, an organic aluminum oxy compound, and an optional organic aluminum compound which is added as necessary.

The Group 4 transition metal in this case is zirconium, titanium or hafnium, and these transition metals have at least one ligand containing a cyclopentadienyl skeleton. Here, the ligand containing a cyclopentadienyl skeleton may be exemplified by a cyclopentadienyl group which may be substituted with an alkyl group or an indenyl group, a tetrahydroindenyl group, or a fluorenyl group. These groups may be bound via another group such as an alkylene group or the like. Also, ligands other than the ligands containing a cyclopentadienyl skeleton include an alkyl group, a cycloalkyl group, an aryl group, an aralkyl group, and the like.

Furthermore, for the organic aluminum oxy compound and the organic aluminum compound, those typically used for the preparation of olefinic resins can be used. Such solid state Group 4 metallocene catalysts are described in, for example, JP-A No. 61-221206, JP-A No. 64-106, JP-A No. 2-173112, and the like.

Examples of the other monomer which may be used together with the cyclic olefin monomer include 1-butene, 1-pentene, 1-hexene, 1-octene, 1-butene, 2-pentene, 1,4-hexadiene, cyclopentene, and the like. By using these other monomers, the molecular weight or properties of the cyclic olefin polymer can be controlled.

Hereinafter, the cyclic olefin monomer represented by the following Formula [I] or [II] will be described.

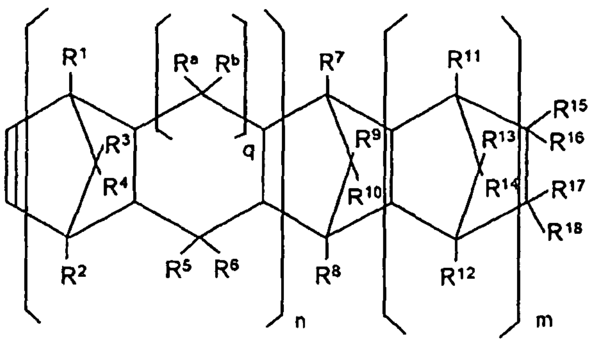

...(I)

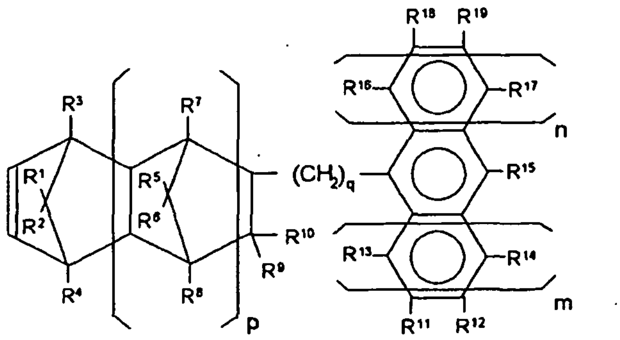

...(II)

In the Formula [I], n is 0 or 1; m is 0 or a positive integer; and q is 0 or 1. If q is 1, $R^a$ and $R^b$ are each independently an atom or a hydrocarbon group as described below; and if q is 0, the bonds are bound to each other to form a 5-membered ring.

$R^1$ to $R^{18}$ and $R^a$ and $R^b$ are each independently a hydrogen atom, a halogen atom or a hydrocarbon group. Here, the halogen atom includes a fluorine atom, a chlorine atom, a bromine atom or an iodine atom.

The hydrocarbon group which is independently used in $R^1$ to $R^{18}$ and $R^a$ and $R^b$ includes an alkyl group having 1 to 20 carbon atoms, a cycloalkyl group having 3 to 15 carbon atoms, an aromatic hydrocarbon group. More specifically, the alkyl group may be exemplified by a methyl group, an ethyl group, a propyl group, an isopropyl group, an amyl group, a hexyl group, an octyl group, a decyl group, a dodecyl group or an octadecyl group. The cycloalkyl group may be exemplified by a cyclohexyl group, while the aromatic hydrocarbon group may be exemplified by a phenyl group, a naphthyl group or the like. These hydrocarbon groups may be substituted with halogen atoms.

Moreover, in the Formula [I], $R^{15}$ to $R^{18}$ may be bound to each other (jointly) to form a monocyclic ring or a polycyclic ring, and also, the monocyclic ring or polycyclic ring thus formed may have double bonds. Specific examples of the formed monocyclic ring or polycyclic ring will be presented in the following.

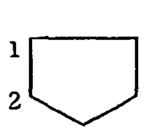 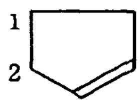 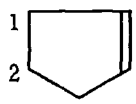 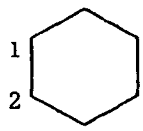 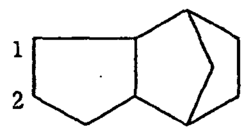

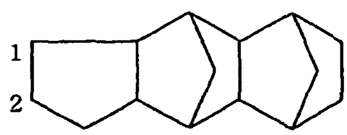 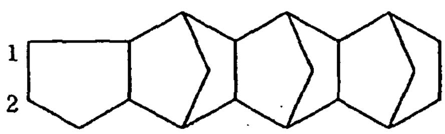

With regard to the illustration above, the carbon atoms assigned with number 1 or 2 represent the carbon atoms to which $R^{15}$ ($R^{16}$) or $R^{17}$ ($R^{18}$) of the Formula [I] is bound, respectively. Furthermore, $R^{15}$ and $R^{16}$, or $R^{17}$ and $R^{18}$ may form an alkylidene group. Such alkylidene group is typically an alkylidene group having 2 to 20 carbon atoms, and specific examples of this alkylidene group include an ethylidene group, a propylidene group and an isopropylidene group.

In the Formula [II], p and q are each 0 or a positive integer, while m and n are each 0, 1 or 2. $R^1$ to $R^{19}$ are each independently a hydrogen atom, a halogen atom, a hydrocarbon group or an alkoxy group.

The halogen atom has the same meaning as the halogen atoms defined for the Formula [I]. The hydrocarbon group may be exemplified by an alkyl group having 1 to 20 carbon atoms, a halogenated alkyl group having 1 to 20 carbon atoms, a cycloalkyl group having 3 to 15 carbon atoms, or an aromatic hydrocarbon group, for each independently. More specifically, the alkyl group may be exemplified by a methyl group, an ethyl group, a propyl group, an isopropyl group, an amyl group, a hexyl group, an octyl group, a decyl group, a dodecyl group or an octadecyl group. The cycloalkyl group may be exemplified by a cyclohexyl group, while the aromatic hydrocarbon group may be exemplified by an aryl group or an aralkyl group, specifically, a phenyl group, a tolyl group, a naphthyl group, a benzyl group, a phenylethyl group or the like. The alkoxy group may be exemplified by a methoxy group, an ethoxy group, a propoxy group or the like. These hydrocarbon groups and alkoxy groups may be substituted with a fluorine atom, a chlorine atom, a bromine atom or an iodine atom.

Here, the carbon atom to which $R^9$ and $R^{10}$ are bound, and the carbon atom to which $R^{13}$ is bound or the carbon atom to which $R^{11}$ is bound may be bound directly, or via an alkylene group having 1 to 3 carbon atoms. That is, in the case where the two carbon atoms mentioned above are bound via an alkylene group, the groups represented by $R^9$ and $R^{13}$, or the groups represented by $R^{10}$ and $R^{11}$ are jointly formed any alkylene group among a methylene group ($-CH_2-$), an ethylene group ($-CH_2CH_2-$) and a propylene group ($-CH_2CH_2CH_2-$). Furthermore, when n = m = 0, $R^{15}$ and $R^{12}$, or $R^{15}$ and $R^{19}$ may be bound to each other to form a monocyclic or polycyclic aromatic ring. The monocyclic or polycyclic aromatic ring in this case may be exemplified by the following groups in which when n = m = 0, $R^{15}$ and $R^{12}$ are further forming aromatic rings.

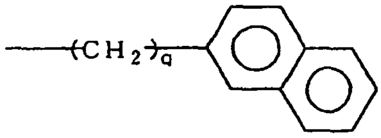

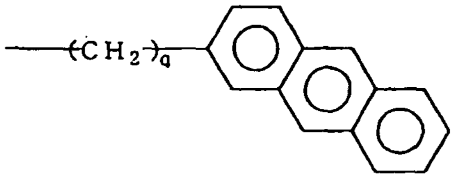

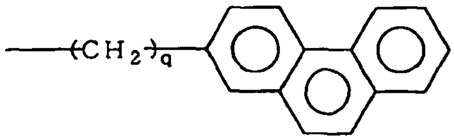

In these formulas, q has the same meaning as the q in Formula [II].

More specific examples of the cyclic olefin monomer represented by Formula [I] or [II] as described above are as follows.

As an example, bicyclo[2.2.1]-2-heptene represented by the formula:

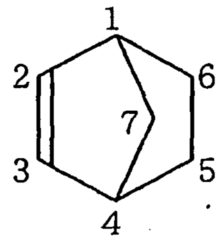

(also known as norbornene; in the formula, the numbers 1 to 7 represent the location numbers of carbon atoms), and derivatives resulting from substitution of the compound with hydrocarbon groups may be mentioned.

Examples of these hydrocarbon groups include 5-methyl, 5,6-dimethyl, 1-methyl, 5-ethyl, 5-n-butyl, 5-isobutyl, 7-methyl, 5-phenyl, 5-methyl-5-phenyl, 5-benzyl, 5-tolyl, 5-(ethylphenyl), 5-(isopropylphenyl), 5-(biphenyl), 5-(β-naphthyl), 5-(a-naphthyl), 5-(anthracenyl), 5,6-diphenyl, and the like.

As other derivatives, bicyclo[2.2.1]-2-heptene derivatives such as:

a cyclopentadiene-acenaphthylene adduct,
1,4-methano-1,4,4a,9a-tetrahydrofluorene,
1,4-methano-1,4,4a,5,10,10a-hexahydroanthracene and the like may be mentioned.

In addition to these, tricyclo[4.3.0.$1^{2,5}$]-3-decene derivatives such as tricyclo[4.3.0.$1^{2,5}$]-3-decene, 2-methyltricyclo[4.3.0.$1^{2,5}$]-3-decene, 5-methyltricyclo[4.3.0.$1^{2,5}$]-3-decene and the like, tricyclo[4.3.0.$1^{2,5}$ ]deca-3,7-diene, tricyclo[4.4.0.$1^{2,5}$]-3-undecene derivatives such as tricyclo[4.4.0.$1^{2,5}$]-3-undecene, 10-methyltricyclo[4.4.0.$1^{2,5}$]-3-undecene and the like,
tetracyclo[4.4.0.$1^{2,5}$.$1^{7,10}$]-3-dodecene represented by the formula:

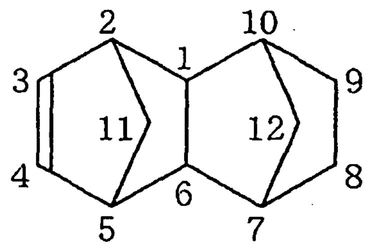

(may be simply referred to as tetracyclododecene; in the formula, the numbers 1 to 12 represent the location numbers of carbon atoms) and derivatives resulting from substitution of this compound with hydrocarbon groups may be mentioned.

Examples of these hydrocarbon groups include 8-methyl, 8-ethyl, 8-propyl, 8-butyl, 8-isobutyl, 8-hexyl, 8-cyclohexyl, 8-stearyl, 5,10-dimethyl, 2,10-dimethyl, 8,9-dimethyl, 8-ethyl-9-methyl, 11,12-dimethyl, 2,7,9-trimethyl, 2,7-dimethyl-9-ethyl, 9-isobutyl-2,7-dimethyl, 9,11,12-trimethyl, 9-ethyl-11, 12-dimethyl, 9-isobutyl-11, 12-dimethyl, 5,8,9,10-tetramethyl, 8-ethylidene, 8-ethylidene-9-methyl, 8-ethylidene-9-ethyl, 8-ethylidene-9-isopropyl, 8-ethylidene-9-butyl, 8-n-propylidene, 8-n-propylidene-9-methyl, 8-n-propylidene-9-ethyl, 8-n-propylidene-9-isopropyl; 8-n-propylidene-9-butyl, 8-isopropylidene, 8-isopropylidene-9-methyl, 8-isopropylidene-9-ethyl, 8-isopropylidene-9-isopropyl, 8-isopropylidene-9-butyl, 8-chloro, 8-bromo, 8-fluoro, 8,9-dichloro, 8-phenyl, 8-methyl-8-phenyl, 8-benzyl, 8-tolyl, 8-(ethylphenyl), 8-(isopropylphenyl), 8,9-diphenyl, 8-(biphenyl), 8-(β-naphthyl), 8-(α-naphthyl), 8-(anthracenyl), 5,6-diphenyl and the like.

As stilll other derivatives, an adduct of acenaphthylene and cyclopentadiene, and the like may be mentioned.

Furthermore, pentacyclo [ 6.5.1.$1^{3,6}$. $0^{2,7}$. $0^{9,13}$]-4-pentadecene, and derivatives thereof,
pentacyclo [ 7.4.0.$1^{2,5}$. $1^{9,12}$. $0^{8,13}$ ]-3-pentadecene, and derivatives thereof,
pentacyclopentadiene compounds such as pentacyclo [6.5.1.$1^{3,6}$.$0^{2,7}$.$0^{9,13}$] -4, 10-pentadecadiene and the like,
pentacyclo [8.4.0.$1^{2,5}1^{9,12}$.$0^{8,13}$]-3-hexadecene, and derivatives thereof,
pentacyclo [ 6.6.1.$1^{3,6}$.$0^{2,7}$.$0^{9,14}$]- 4-hexadecene, and derivatives thereof,
hexacyclo [6.6.1.$1^{3,6}$.$1^{10,13}$.$0^{2,7}$.$0^{9,14}$]-4-heptadecene, and derivatives thereof,
heptacyclo [8.7.0.$^{2,9}$.$1^{4,7}$.$1^{11,17}$.$0^{3,8}$.$0^{12,16}$]-5-eicosene, and derivatives thereof,
heptacyclo [8.8.0.$1^{2,9}$.$1^{4,7}$.$1^{11,18}$.$0^{3,8}$.$0^{12,17}$]-5heneicosene, and derivatives thereof,
octacyclo [8.8.0.$1^{2,9}$.$1^{4,7}$.$1^{11,18}$.$1^{13,16}$.$0^{3,8}$.$0^{12,17}$]-5-docosene, and derivatives thereof,
nonacyclo [10.9.1. $1^{4,7}$.$1^{13,20}$ . $1^{15,18}$.$0^{2,10}$. $0^{3,8}$ $0^{12,21}$. $0^{14,19}$]-5-pentacosene, and derivatives thereof,
nonacylo [10.10. 1. $1^{5,8}$.$1^{14,21}$.$1^{16,19}$.$0^{2,11}$.$0^{4,9}$.$0^{13,22}$.$0^{15,20}$]-6-hexacosene, and derivatives thereof, and the like may be mentioned.

Specific examples of the cyclic olefin monomer represented by the General Formula [I] or [II] have been presented in the above. Furthermore, more specific structural examples of these compounds may be exemplified by the structural examples of the cyclic olefin monomers shown in Paragraphs [0032] to [0054] in the specification of JP-A No. 7-145213. The cyclic olefin resins used for the invention may contain two or more of the units derived from the cyclic olefin monomers disclosed above.

The cyclic olefin monomer represented by the General Formula [I] or [II] as described above can be produced by a Diels-Alder reaction between subjecting cyclopentadiene and olefins having the corresponding structures. It is preferable that the cyclic olefin monomer used in the polymerization has high purity. The purity is usually 99% or higher, preferably 99.6% or higher, and more preferably 99.9% or higher.

(Process for producing ring-opening polymer)

If the cyclic olefin polymer is a ring-opening polymer, the polymer can be produced by, for example, polymerizing or copolymerizing the cyclic olefin monomer represented by the Formula [I] described above in the presence of a catalyst for a ring-opening polymerization.

As the cyclic olefin monomer represented by the Formula [I], it is preferable to use tricyclo[4.3.0.$1^{2,5}$]deca-3,7-diene.

Examples of other monomers that can be used together with the cyclic olefin monomer include 1-butene, 1-pentene, 1-hexene, 1-octene, 1-butene, 2-pentene, 1,4-hexadiene, cyclopentene and the like. By using these other monomers, the molecular weight or properties of the cyclic olefin polymer can be controlled.

As the catalyst for ring-opening polymerization, a catalyst comprising a halide, nitrate or acetylacetone compound of a metal selected from ruthenium, rhodium, palladium, osmium, indium, platinum and the like, and a reducing agent, or a catalyst comprising a halide or acetylacetone compound of a metal selected from titanium, palladium, zirconium, molybdenum and the like, and an organic aluminum compound, can be used.

According to the invention, the ring-opening polymer can be produced without using a solvent, but it is usually preferable to produce the polymer in an inert organic solvent. Specific examples of the organic solvent include aromatic hydrocarbons such as benzene, toluene, xylene and the like; aliphatic hydrocarbons such as n-pentane, hexane, heptane and the like; alicyclic hydrocarbons such as cyclohexane and the like; halogenated hydrocarbons such as methylene dichloride, dichloroethane, dichloroethylene, tetrachloroethane, chlorobenzene, dichlorobenzene, trichlorobenzene and the like; and the like.

(Hydrogenation product of ring-opening polymer)

Production of a hydrogenation product of the ring-opening polymer is performed by hydrogenating at least a part of the carbon-carbon double bonds of the ring-opening polymer by a conventional method. The method for subjecting the ring-opening polymer to hydrogenation is not particularly limited, and can be carried out by subjecting the ring-opening polymer to hydrogenation in an organic solvent in the presence of a hydrogenation catalyst.

The hydrogenation reaction can be performed according to a standard method by contacting a resin composition containing the ring-opening polymer in a solution state with hydrogen in the presence of a hydrogenation catalyst. As the hydrogenation catalyst, a homogeneous catalyst or a heterogeneous catalyst can be used. The heterogeneous catalyst has excellent production efficiency with advantages such as attaining high activity under high temperature and high pressure, inducing hydrogenation within a short time, easy removal, and the like.

The heterogeneous catalyst may be exemplified by a catalyst formed by supporting a metal selected from the group consisting of nickel, ruthenium, rhenium, platinum, palladium and rhodium, on a support. The support is not particularly limited, and adsorbents such as alumina, diatomaceous earth and the like that are conventionally used for supporting hydrogenation catalyst metals, can be used.

The amount of supported nickel is 20 to 80% by weight, and preferably 30 to 60% by weight. The amount of supported palladium or platinum is 0.1 to 10% by weight, and preferably 2 to 7% by weight. The form is not particularly limited, and may be powder, solid or the like. It is desirable to use any form in accordance with the apparatus used.

The hydrogenation reaction according to the invention can be performed using any reaction vessel, but in view of continuous operability, it is preferable to use a fixed bed type reactor. The fixed bed type reactor may be exemplified by (a) a packed tower or tray tower type reactor, (b) a fixed catalyst reactor, (c) a mesh or thin layer catalyst reactor, or the like.

In the packed tower or tray tower type reactor (a), a resin composition containing the ring-opening polymer in a solution state and hydrogen gas are subjected to cross flow contact, counter-current contact or co-current contact in a tower packed with catalyst particles.

The fixed bed catalyst reactor (b) can be classified to isothermal bed type, adiabatic bed type, multistage adiabatic bed type, self-heat exchanging type, external heat exchanging type, and the like. Any type may be used for the hydrogenation reaction of the invention. A representative example of the fixed bed catalyst reactor is a reactor (b) of the type such as that described in J.H. Gary and G.E. Handwerk, Petroleum Refining Technology and Economics (1975), p.74, that is, a reactor which is packed with ceramic balls on the bottom and is packed with catalyst particles in the central part of the reactor above the ceramic balls and is constituted such that a mixture of a resin composition containing a ring-opening polymer in a solution-state and a gas is fed from the top plate of the reactor, and the reaction product is discharged from the bottom plate of the reactor.

The metal mesh or thin layer catalyst reactor (c) is a reactor in which several sheets to several tens of sheets of thin layers of metal mesh or particulate catalyst are mounted. The reactor is classified into a radial flow type and a parallel flow type according to the method of running a resin composition containing a ring-opening polymer in a solution state, but any type may be used.

With regard to the method for hydrogenation according to the invention, when a resin composition containing a ring-opening polymer in a solution state is passed through the fixed bed, it is preferable to allow the resin composition to flow over the surface of catalyst particles forming a film. The flow direction of the resin composition containing a ring-opening polymer in a solution state and the hydrogen gas may be co-current or counter-current, but from the view points of easy modification of operating conditions, the co-current mode is preferred.

The reactor used for the method for hydrogenation according to the invention is a reactor mounted with a fixed bed packed with a hydrogenation catalyst. This reactor is constituted such that a resin composition containing a ring-opening polymer in a solution state is filled in the reactor, and with the catalyst packed fixed bed being impregnated with the resin composition, hydrogen is blown thereinto. The reaction is typically performed in a batch mode. A representative example of the reactor is a reactor such as that described in Journal of Chemical Engineering of Japan, Vol. 27, No. 3 (1994), p. 310, that is, a reactor in which a cylindrical mesh basket made of stainless steel packed with catalyst particles on a frame mounted on a rotating axis is attached as a fixed bed, and which is further equipped with a stirrer. This reactor is filled with a resin composition containing a ring-opening polymer in a solution state, and with the catalyst packed basket being impregnated with the resin composition, the catalyst packed basket is allowed to rotate about the rotating

axis. While stirring the resin composition, hydrogen gas is flooded into the lower part of the reactor. In another example, there is also used a reactor in which a cage formed by packing a catalyst inside the double cylinders of a double cylindrical mesh basket is disposed as a fixed bed, apart from the inner wall of the reactor with a slight gap, and a stirring blade is attached to a rotating axis at the center of the double cylinder.

With the method for hydrogenation according to the invention, the resin composition containing a ring-opening polymer, which is provided for the method for hydrogenation, is a solution having a ring-opening polymer and the like dissolved in an organic solvent. This resin composition is supplied to the reactor in a solution state, and the ring-opening polymer and the like are subjected to hydrogenation. The resin composition containing a ring-opening polymer is obtained as a reaction solution after producing the ring-opening polymer, and thus it is not particularly necessary to add the organic solvent, but the following organic solvents may be added. Such organic solvent is not particularly limited as long as it is inert to the catalyst, but from the viewpoint of excellent solubility for the hydrogenation product generated, hydrocarbon solvents are typically used. Examples of the hydrocarbon solvent include aromatic hydrocarbons such as benzene, toluene and the like; aliphatic hydrocarbons such as n-pentane, hexane and the like; alicyclic hydrocarbons such as cyclohexane, methylcyclohexane, decalin, bicyclononane and the like; and the like, and among these, cyclic alicyclic hydrocarbons are preferred. These organic solvent can be used individually, or in combination of two or more species. Typically, the solvent may be the same as the solvent used for the polymerization reaction.

The hydrogenation reaction can be performed according to a standard method, but depending on the type of the hydrogenation catalyst or the reaction temperature, the rate of hydrogenation varies, and the residual ratio of the aromatic ring can also be altered. Thus, in the case of using the hydrogenation catalyst described above, in order to retain the unsaturated bonds in the aromatic ring to some extent, control may be performed such as lowering the reaction temperature, decreasing the hydrogen pressure, shortening the reaction time, or the like.

The operating temperature when hydrogenating the ring-opening polymer is 0 to 150°C, preferably 60 to 130°C, and more preferably 80 to 120°C.

The pressure is 1 to 50 kg/cm$^2$, preferably 1 to 30 kg/cm$^2$, and more preferably 1 to-20 kg/cm$^2$. Also, the reaction time, although it depends on the hydrogenation catalyst used, is 1 hour or shorter, and preferably 30 minutes or shorter.

The LHSV for the hydrogenation reaction is usually 1 to 10, and preferably 3 to 5. Here, the LHSV is a reciprocal of the residence time, and can be calculated from the feed flow rate of the cyclic olefin resin composition (A) which is obtained by polymerizing a cyclic olefin monomer in a hydrocarbon solvent, and contains unreacted cyclic olefin monomer, divided by the volume of catalyst packing.

The resin composition containing a hydrogenated ring-open polymer, which composition has been discharged from the fixed bed reactor, is introduced into a separator, such as a flash separator, to separate the resin composition and unreacted hydrogen. The separated hydrogen can be recycled to the hydrogenation reactor.

<(B) Flexible copolymer>

The flexible copolymer (B) used for the invention is produced by polymerizing at least two or more monomers selected from the group consisting of an olefin compound, a diene compound, and an aromatic vinyl hydrocarbon compound. These olefin compound, diene compound and aromatic vinyl hydrocarbon compound respectively comprise a plurality of compounds. That is, the flexible copolymer (B) is obtained by polymerizing at least two or more monomers selected from the group consisting of a plurality of olefin compounds, a plurality of diene compounds and a plurality of aromatic vinyl hydrocarbon compounds. This flexible copolymer (B) has a glass transition temperature of 0°C or lower.

By using a resin composition containing such flexible copolymer (B), a substrate having excellent heat resistance can be produced.

As the flexible copolymer (B), preferably at least one or more flexible copolymers selected from the group consisting of the following polymers (i), (ii), (iii) and (iv) can be used.

(i) A cyclic olefin random copolymer formed from ethylene, another $\alpha$-olefin, and a cyclic olefin represented by the following General Formula (III), and having a glass transition temperature (Tg) of 0°C or lower.

(ii) An amorphous or low-crystalline $\alpha$-olefin polymer formed from at least two kinds of $\alpha$-olefins and having a glass transition temperature (Tg) of 0°C or lower.

(iii) An $\alpha$-olefin diene copolymer formed from at least two $\alpha$-olefins and at least one non-conjugated diene, and having a glass transition temperature (Tg) of 0°C or lower.

(iv) An aromatic vinyl hydrocarbon-conjugated diene random or block copolymer having a glass transition temperature (Tg) of 0°C or lower, or a hydrogenation product thereof.

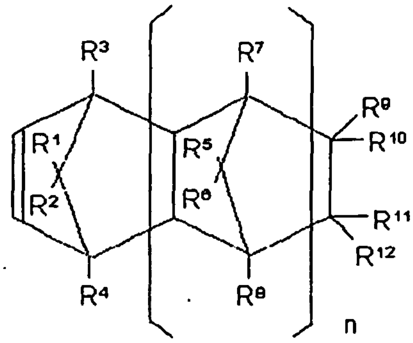

[III]

wherein $R^1$ to $R^{12}$ are each a hydrogen atom, a hydrocarbon group or a halogen atom, and may be identical or different, and furthermore $R^9$ and $R^{10}$, or $R^{11}$ and $R^{12}$ may be jointly formed a divalent hydrocarbon group, or $R^9$ or $R^{10}$ and $R^{11}$ or $R^{12}$ may form a ring with each other; n is 0 or a positive integer; and $R^5$ to $R^8$, when repeated plural times, may be identical or different.

((i) Cyclic olefin random copolymer)

The cyclic olefin random copolymer (i) (hereinafter, may be simply referred to as "copolymer (i)"), which is used as a flexible copolymer (B), is a copolymer containing ethylene, another α-olefin and the above-described cyclic olefin-derived structural unit. According to the invention, in addition to these monomers, other copolymerizable unsaturated monomers may be used as necessary, within the scope of not impairing the purpose of the invention. The another α-olefin may be exemplified by an α-olefin having 3 to 20 carbon atoms, such as propylene, 1-butene, 4-methyl-l-pentene, 1-hexene, 1-octene, 1-decene, 1-dodecene, 1-tetradecene, 1-hexadecene, 1-octadecene, 1-eicosene or the like. One or two or more structural units derived therefrom may be contained in the copolymer (i) as the flexible copolymer (B).

With regard to the cyclic olefin random copolymer (i), the structural unit derived from ethylene (a1) is suitably contained in an amount ranging from 40 to 98% by mole, preferably 50 to 90% by mole; the structural unit derived from another α-olefin (b1) is contained in an amount ranging from 2 to 50% by mole, and preferably 5 to 40% by mole; and the structural unit derived from cyclic olefin (c1) is suitably contained in an amount of 2 to 20% by mole, and preferably 2 to 15% by mole. The structural unit derived from ethylene (a1), the structural unit derived from the another α-olefin (b1) and the structural unit derived from the cyclic olefin component (c1) are arranged in a random manner, and form a substantially linear cyclic olefin random copolymer. The fact which the copolymer (i) is the flexible copolymer (B) is substantially linear and does not have a gel-like crosslinked structure can be verified from that the same copolymer completely dissolves in decalin at 135°C.

As the copolymer (i), one having a glass transition temperature (Tg) in the range of 0°C or lower, preferably -10°C or lower, and more preferably -20°C or lower, is used.

Also, as the copolymer (i), it is preferable to use one having an intrinsic viscosity [η], as measured in decalin at 135°C, in the range of 0.01 to 10 dl/g, and preferably 0.08 to 7 dl/g.

As the copolymer (i) as the flexible copolymer (B), only a copolymer having the properties in the above-described ranges may be used, but if the property values of the composition as a whole are included in the ranges, a copolymer having properties out of the ranges may be partially contained.

In addition, the cyclic olefin polymer (A), and the copolymer (i) as the flexible copolymer (B) can be produced according to the methods suggested by the Applicant in JP-A No. 60-168708, JP-A No. 61-120816, JP-A No. 61-115912, JP-A No. 61-115916, JP-A No. 61-271308, JP-A No. 61-272216, JP-A No. 62-252406, JP-A No. 62-252407, and the like, by selecting appropriate conditions.

((ii) Amorphous or low-crystalline α-olefin polymer)

The amorphous or low-crystalline α-olefin polymer (ii) (hereinafter, may be simply referred to "polymer (ii)"), which is a flexible copolymer (B), is an amorphous or low-crystalline α-olefin polymer which is formed from at least two kinds of α-olefins, and has a glass transition temperature (Tg) in the range of 0°C or lower, preferably - 10°C, and more preferably -20°C. Specifically, (a2) an ethylene α-olefin copolymer, (b2) a propylene α-olefin copolymer, and the like are used.

The α-olefin constituting the ethylene-α-olefin copolymer (a2) may be exemplified by an α-olefin typically having

3 to 20 carbon atoms, such as propylene, 1-butene, 1-pentene, 1-hexene, 4-methyl-1-pentene, 1-octene, 1-decene, mixtures of these, or the like. Among these, an α-olefin having 3 to 10 carbon atoms is particularly preferred.

Furthermore, the α-olefin constituting the propylene α-olefin copolymer (b2) may be exemplified by an α-olefin typically having 4 to 20 carbon atoms, such as 1-butene, 1-pentene, 1-hexene, 4-methyl-l-pentene, 1-octene, 1-decene, mixtures of these, or the like. Among these, an α-olefin having 4 to 10 carbon atoms is particularly preferred.

For the ethylene-α-olefin copolymer (a2) as described above, the ratio of ethylene and α-olefin (ethylene/α-olefin) on the molar basis may vary depending on the type of the α olefin, but in general, the ratio is preferably 30/70 to 95/5.

For the propylene.α-olefin copolymer (b2) as described above, the ratio of propylene and α-olefin (propylene/a-olefin) on the molar basis may vary depending on the type of the α-olefin, but in general, the ratio is preferably 30/70 to 95/5.

((iii) α-olefin·diene copolymer)

The a-olefin· diene copolymer (iii) (hereinafter, may be simply referred to as "copolymer (iii)"), which is a flexible copolymer (B), is a copolymer which is formed from at least two α-olefins and at least one non-conjugated diene, and has a glass transition temperature (Tg) in the range of 0°C or lower, preferably -10°C, and more preferably -20°C or lower. Specifically, (a3) an ethylene·α-olefin·diene copolymer rubber, (b3) a propylene·α-olefin·diene copolymer rubber, and the like are used.

The α-olefin constituting the ethylene·α-olefin·diene copolymer rubber (a3) may be exemplified by an α-olefin typically having 3 to 20 carbon atoms, such as propylene, 1-butene, 1-pentene, 1-hexene, 4-methyl-1-pentene, 1-octene, 1-decene, mixtures of these, or the like. Among these, an α-olefin having 3 to 10 carbon atoms is particularly preferred.

Also, the α-olefin constituting the propylene·α-olefin-diene copolymer rubber (b3) may be exemplified by an α-olefin typically having 4 to 20 carbon atoms, such as 1-butene, 1-pentene, 1-hexene, 4-methyl-l-pentene, 1-octene, 1-decene, mixtures of these, or the like. Among these, an α-olefin having 4 to 10 carbon atoms is particularly preferred.

The diene compound used for forming the ethylene-α-olefin·diene copolymer rubber (a3) and the propylene·α-olefin-diene copolymer rubber (b3), may be exemplified by a chain-like non-conjugated diene such as 1,4-hexadiene, 1,6-octadiene, 2-methyl-1,5-hexadiene, 6-methyl-1,5-heptadiene, 7-methyl-1,6-octadiene or the like; cyclohexadiene, dicyclopentadiene; a cyclic non-conjugated diene such as methyltetrahydroindene, 5-vinylnorbornene, 5-ethylidene-2-norbornene, 5-methylene-2-norbornene, 5-isopropylidene-2-norbornene or 6-chloromethyl-5-isopropenyl-2-norbornene; 2,3-diisopropylidene-5-norbornene; 2-ethylidene-3-isopropylidene-5-norbornene; 2-propenyl-2,2-norbornadiene; or the like.

For the ethylene·α-olefin·diene copolymer rubber (a3) as described above, the ratio of ethylene and α-olefin (ethylene/olefin) on the molar basis.may vary depending on the type of the α-olefin, but in general, the ratio is preferably 30/70 to 95/5.

Also, the content of the structural unit derived from a diene compound in this copolymer rubber (a3) is preferably 1 to 20% by mole, and more preferably 2 to 15% by mole.

For the propylene·α-olefin·diene copolymer rubber (b3) as described above, the ratio of propylene and α-olefin (propylene/olefin) on the molar basis may vary depending on the type of the α-olefin, but in general, the ratio is preferably 30/70 to 95/5.

Also, the content of the structural unit derived from a diene compound in this copolymer rubber (b3) is preferably 1 to 20% by mole, and more preferably 2 to 15% by mole.

((iv) Aromatic vinyl hydrocarbon·conjugated diene random or block copolymer, or hydrogenation product thereof)

The aromatic vinyl hydrocarbon·conjugated diene random or block copolymer (iv), or a hydrogenation product thereof (hereinafter, may be simply referred to as "copolymer (iv) or a hydrogenation product"), which is a flexible copolymer (B), has a glass transition temperature (Tg) in the range of 0°C or lower, preferably -10°C or lower, and more preferably -20°C or lower. Specifically, (a4) a styrene·butadiene block copolymer rubber, (b4) a styrene·butadiene·styrene block copolymer rubber, (c4) a styrene·isoprene block copolymer rubber, (d4) a styrene·isoprene·styrene block copolymer rubber, (e4) a hydrogenated styrene·butadiene·styrene block copolymer rubber, (f4) a hydrogenated styrene·isoprene·styrene block copolymer rubber, (g4) a styrene·butadiene random copolymer rubber, and the like are used.

For these copolymer rubbers, in general, the ratio of the aromatic vinyl hydrocarbon compound and the conjugated diene compound (aromatic vinyl hydrocarbon/conjugated diene) on the molar basis is generally preferably 10/90 to 70/30.

The hydrogenated styrene·butadiene·styrene block copolymer rubber (e4) is a copolymer rubber in which part or all of the residual double bonds in the styrene·butadiene·styrene block copolymer (b4) have been hydrogenated.

The hydrogenated styrene·isoprene·styrene block copolymer rubber (f4) is a copolymer in which part or all of the residual double bonds in the styrene·isoprene·styrene block copolymer (d4) have been hydrogenated.

For the polymers (i) to (iv) as the flexible copolymer (B) as described above, it is preferable to use one having

an intrinsic viscosity [η], as measured in decalin at 135°C, in the range of 0.01 to 10 dl/g, and preferably 0.08 to 7 dl/g, and a degree of crystallinity, as measured by an X-ray diffraction method, in the range of 0 to 10%, preferably 0 to 7%, and particularly preferably 0 to 5%. The polymers (i) to (iv) as the flexible copolymer (B) as described above can be used individually, or in combination of two or more species.

Furthermore, the flexible copolymer (B) is easily available from the market, and for example, trade name: Tafmer, Mitsui EPT (Mitsui Chemicals, Inc.), trade name: Kernel (Mitsubishi Chemical Corp.), trade name: Excellen (Sumitomo Chemical Co., Ltd.), trade name: Engage (Dow Chemical Company), trade name: JSR (JSR Corp.), and the like may be appropriately used.

<(C) Modified polyolefin>

For the modified polyolefin (C), any polyolefin having a polar group can be used without particular limitation. The polyolefin used in the invention is formed from a crystalline or amorphous high molecular weight solid product obtained by polymerizing one or more mono-olefins according to either a high pressure method or a low pressure method. Such resin is commercially available.

Specific examples of a suitable raw material olefin for the above-described polyolefin include ethylene, propylene, 1-butene, 1-pentene, 1-hexene, 2-methyl-1-propene, 3-methyl-1-pentene, 4-methyl-1-pentene, 5-methyl-1-hexene, 1-octene, 1-decene, and olefin mixtures of two or more of these olefins. The polymerization mode may be of random type or block type, and is not affected by employing any polymerization mode, as long as a resinous product is obtained.

As the modified polyolefin of the invention, a block copolymer of a polar monomer and an olefin, or even a graft modified polymer obtained by graft copolymerizing a polar monomer onto a polyolefin can be used. A graft modified polymer is particularly suitably used. The raw material polyolefin used for the graft modified polymer can be any of the above-described polyolefins. An ethylenic polymer is particularly suitably used.

The ethylenic polymer used as the raw material of the graft modified ethylenic polymer is preferably an ethylene·α-olefin copolymer. The ethylene·α-olefin copolymer that is used as the raw material of the graft modified ethylenic polymer, is preferably a copolymer of ethylene and an α-olefin having 3 to 10 carbon atoms. Specific examples this α-olefin having 3 to 10 carbon atoms include propylene, 1-butene, 1-pentene, 1-hexene, 3-methyl-1-butene, 3-methyl-1-pentene, 3-ethyl-1-pentene, 4-methyl-1-pentene, 4-methyl-1-hexene, 4,4-dimethyl-1-pentene, 4-ethyl-1-hexene, 1-octene, 3-ethyl-1-hexene, 1-octene, 1-decene and the like. These may be used individually or in combination of two or more species. Among these, at least one or more species among propylene, 1-butene, 1-hexene and 1-octene are particularly preferred.

The respective contents of the constituent units in the ethylenic copolymer are such that the content of the constituent unit derived from ethylene is typically 75 to 95% by mole, and preferably 80 to 95% by mole, while the content of the constituent unit derived from at least one compound selected from the α-olefins having 3 to 10 carbon atoms is typically 5 to 25% by mole, and preferably 5 to 20% by mole.

The ethylene·α-olefin copolymer used in graft modification preferably has the following properties. That is,

(i) the density is 855 to 910 kg/$m^3$, and preferably 857 to 890 kg/$m^3$;
(ii) the melt flow rate (MFR) at 190°C under a load of 2.16 kg is in the range of 0.1 to 100 g/10 minutes, and preferably 0.1 to 20 g/10 minutes;
(iii) the molecular weight distribution index (Mw/Mn) as evaluated by a GPC method is in the range of 1.5 to 3.5, preferably 1.5 to 3.0, and more preferably 1.8 to 2.5; and
(iv) the B value determined from the $^{13}$C-NMR spectrum and the following equation is 0.9 to 1.5, and preferably 1.0 to 1.2:

$$\text{B value} = [POE]/(2\cdot(PE)[PO])$$

wherein [PE] is the molar fraction of the constituent unit derived from ethylene contained in the copolymer; [PO] is the molar fraction of the constituent unit derived from α-olefin contained in the copolymer; and [POE] is the ratio of the number of ethylene·α-olefin sequences to the number of total dyad sequences in the copolymer.

In addition to these, for the ethylene·α-olefin copolymer used as the graft modified ethylenic polymer, polymers having the same characteristics as those described as the ethylene·α-olefin copolymers used as the component (A) are suitably used. The type of comonomer, density, molecular weight of the copolymer and the like may be identical with or different from the component (A).

The graft modified ethylenic polymer according to the invention is obtained by graft modifying the above-described ethylenic copolymer with at least one vinyl compound having a polar group. The vinyl compound having a

polar group may be exemplified by a vinyl compound having an oxygen-containing group such as acid, acid anhydride, ester, alcohol, epoxy, ether or the like; a vinyl compound having a nitrogen-containing group such as isocyanate, amide or the like; a vinyl compound having a silicon-containing group such as vinylsilane or the like; or the like.

Among these, a vinyl compound having an oxygen-containing group is preferred, and unsaturated epoxy monomers, unsaturated carboxylic acid and derivatives thereof are preferred.

The unsaturated epoxy monomer may be exemplified by an unsaturated glycidyl ether, an unsaturated glycidyl ester (for example, glycidyl methacrylate), or the like.

Examples of the unsaturated carboxylic acid include acrylic acid, maleic acid, fumaric acid, tetrahydrophthalic acid, itaconic acid, citraconic acid, crotonic acid, isocrotonci acid, Nadic acid™ (endocis-bicyclo[2.2.1]hept-5-ene-2,3-dicarboxylic acid), and the like.

Examples of the derivatives of the unsaturated carboxylic acid include acid halide compounds, amide compounds, imide compounds, acid anhydrides, and ester compounds and the like of above-mentioned unsaturated carboxylic acid. Specifically, malenyl chloride, maleimide, maleic anhydride, citraconic anhydride, monomethyl maleate, dimethyl maleate, glycidyl maleate and the like may be mentioned.

Among these, unsaturated dicarboxylic acids or acid anhydrides thereof are suitable, and maleic acid, Nadic acid™ or acid anhydrides thereof are particularly suitable. In addition, the graft position at which the unsaturated carboxylic acid or a derivative thereof is grafted onto a unmodified ethylenic copolymer as described above is not particularly limited, and it is desirable if the unsaturated carboxylic acid or a derivative thereof is bound to any arbitrary carbon atom of the ethylenic polymer which constitutes this graft modified ethylenic polymer.

The graft modified ethylenic polymer as described above can be prepared using a variety of traditionally known methods, for example, the following methods.

(1) A method of melting the unmodified ethylenic polymer in an extruder or the like, adding an unsaturated carboxylic acid, and performing graft copolymerization.

(2) A method of dissolving the unmodified ethylenic polymer in a solvent, adding an unsaturated carboxylic acid and the like, and performing graft copolymerization.

In any of the methods, it is preferable to perform the grafting reaction in the presence of a radical initiator, in order to efficiently graft copolymerize the graft monomer such as unsaturated carboxylic acid or the like.

As the radical initiator, organic peroxides, azo compounds and the like are used. Specific examples of such radical initiator include organic peroxides such as benzoyl peroxide, dichlorobenzoyl peroxide, dicumyl peroxide and the like; azo compounds such as azobisisobutylnitrile, dimethylazoisobutyrate and the like; and the like. Among these, dialkyl peroxides such as dicumyl peroxide, di-tert-butyl peroxide, 2,5-dimethyl-2,5-di(tert-butylperoxy)hexyne, 3,2,5-dimethyl-2,5-di(tert-butylperoxy)hexane, 1,4-bis(tert-butylperoxyisopropyl)benzene and the like are preferably used.

These radical initiators are used in an amount of typically 0.001 to 1 part by weight, preferably 0.003 to 0.5 parts by weight, and more preferably 0.05 to 0.3 parts by weight, based on 100 parts by weight of the unmodified ethylenic polymer.

In a grafting reaction using a radical initiator as described above, or in a grafting reaction performed without using a radical initiator, the reaction temperature is set to the range of typically 60 to 350°C, and preferably 150 to 300°C.

The modified polyolefin (C) is easily available from the market, and for example, trade name: Admar (Mitsui Chemicals, Inc.), trade name: Modic (Mitsubishi Chemical Corp.), trade name: Adtex (Japan Polychem Corp.), trade name: Bynel (DuPont Company), trade name: Plexar (Equistar Chemical Company), trade name: Orevac (Arkema, Inc.), trade name: Umex (Sanyo Chemical Industries, Ltd.), and the like can be suitably used.

<(D) Radical initiator>

As the radical initiator (D), the same radical initiators as those described for the production of the modified polyolefin (C) can be used.

<(E) Polyfunctional compound having two or more radical polymerizable functional groups in the molecule>

The polyfunctional compound having two or more radical polymerizable functional groups (E) (hereinafter, may be simply referred to as "polyfunctional compound (E)") may be exemplified by divinylbenzene, vinyl acrylate, vinyl methacrylate, triarylisocyanurate, diarylphthalate, ethylene dimethacrylate, trimethylolpropane trimethacrylate or the like.

The cyclic olefin resin composition of the present invention comprises the cyclic olefin polymer (A), flexible copolymer (B), modified polyolefin (C), and radical initiator (D) described above. Specifically, the resin composition comprises a reaction product obtained from the component (A), component (B), component (C) and component (D) in combination. Also, according to the invention, the resin composition preferably contains the polyfunctional compound

having two or more radical polymerizable functional groups in the molecule (E), as described above. That is, according to the invention, when the resin composition is formed from a reaction product obtained from these components (A), (B), (C) and (D) together with the component (E) in combination, a crosslinked resin composition having more excellent heat resistance is obtained and is suitable for a substrate for high frequency circuit.

<(F) Inorganic filler>

The cyclic olefin resin composition of the present embodiment may contain, if necessary, an inorganic filler (F). As the inorganic filler (F), silica, diatomaceous earth, alumina, titanium oxide, magnesium oxide, pumice powder, pumice balloon, aluminum hydroxide, magnesium hydroxide, basic magnesium carbonate, dolomite, calcium sulfate, potassium titanate, barium sulfate, calcium sulfite, talc, clay, mica, asbestos, glass fiber, glass flake, glass bead, calcium silicate, montmorillonite, bentonite, graphite, aluminum powder, molybdenum sulfide, boron fiber, silicon carbide fiber, carbon fiber and the like are used.

The average particle size of the inorganic filler is preferably 0.01 to 1000 μm, more preferably 0.05 to 500 μm, and even more preferably 0.1 to 100 μm. If the particle size of the inorganic filler is within the above-mentioned range, the filler has good miscibility, and sufficient heat resistance, which is one of the effects of the invention, is obtained, which is preferable. For the shape of the inorganic filler, any of spherical fillers, and non-spherical fillers such as fractured shape, flake shape, rod shape, plate shape, scale shape and the like can be used. From the viewpoint of packing into the resin, the spherical shape is preferred.

<Other components>

According to the present embodiment, the cyclic olefin resin composition may be blended with the following components, if necessary, in addition to the components (A), (B), (C) and (D), or the components (A), (B), (C), (D) and (E), or the components (A), (B), (C), (D), (E) and (F), as described above.

Specifically, a heat resistant stabilizer, a weather resistant stabilizer, an antistatic agent, a slipping agent, an anti-blocking agent, an antifogging agent, a lubricant, a dye, a pigment, natural oil, synthetic oil, wax, an organic or inorganic filler, and the like may be mentioned. The mixing ratio is an appropriate amount.

Specific examples of the stabilizer which is mixed in as an arbitrary component include phenolic antioxidants such as tetrakis[methylene-3-(3,5-di-t-butyl-4-hydroxyphenyl)propionate]methane, β-(3,5-di-t-butyl-4-hydroxyphenyl) propionic acid alkyl ester, 2,2'-oxamidebis[ethyl-3-(3,5-di-t-butyl-4-hydoxyphenyl)propionate, and the like;
fatty acid metal salts such as zinc stearate, calcium stearate, calcium 12-hydroxystearate and the like;
polyhydric alcohol fatty acid esters such as glycerin monostearate, glycerin monolaurate, glycerin distearate, pentaerythritol monostearate, pentaerythritol distearate, penterythritol tristearate and the like;
and the like.

These may be added individually or in combination. For example, tetrakis[methylene-3-(3,5-di-t-butyl-4-hydroxyphenyl)propionate]methane, and a combination of zinc stearate and glycerin monostearate, and the like may be mentioned.

<Cyclic olefin resin composition>

The cyclic olefin resin composition of the present embodiment comprises a reaction product of the components (A), (B), (C) and (D), or the components (A), (B), (C), (D) and (E) as described above. The respective proportions of the raw materials to obtain a reaction product are 35 to 85 parts by weight of the component (A), 10 to 60 parts by weight of the component (B), and 5 to 55 parts by weight of the component (C) (100 parts by weight of the sum of (A), (B) and (C)). It is preferable that the respective components are used at proportions of preferably 40 to 80 parts by weight of the component (A), 10 to 50 parts by weight of the component (B), 10 to 50 parts by weight of the component (C) (100 parts by weight of the total amount of (A), (B) and (C)), and particularly preferably 40 to 80 parts by weight of the component (A), 10 to 30 parts by weight of the component (B), 10 to 30 parts by weight of the component (C) (100 parts by weight of the total amount of (A), (B) and (C)).

Furthermore, based on 100 parts by weight of total amount of the components (A), (B) and (C), the component (D) is in the range of 0.01 to 5 parts by weight, and preferably 0.05 to 3 parts by weight. Moreover, in the case of using the component (E) in combination, the component (E) is used in an amount of 0 to 5 parts by weight, and preferably 0.01 to 3 parts by weight, based on 100 parts by weight of the total amount of the components (A), (B) and (C). By using a cyclic olefin resin composition containing the raw materials at the respective proportions in the above-described ranges, a substrate having excellent rigidity, low water absorbability, excellent hardness and the like, as well as excellent heat resistance or excellent adhesiveness to electroconductive materials, can be obtained. This substrate, due to its excellent dielectric properties, can be suitably used for substrates for high frequency circuit.

The substrate for high frequency circuit, which is formed from the crosslinked heat resistant cyclic olefin resin composition of the invention, contains an inorganic filler (F), if necessary, in addition to the reaction product of the components (A), (B), (C) and (D), or the components (A), (B), (C), (D) and (E). In the case of containing the inorganic filler (F), the inorganic filler is contained in an amount of 0 to 600 parts by weight, preferably 50 to 500 parts by weight, and more preferably 100 to 400 parts by weight, based on 100 parts by weight of the total amount of the components (A), (B), (C), (D) and (E).

The cyclic olefin resin composition of the present invention can be produced by allowing the component (A), component (B), component (C) and component (D) to react in the above-mentioned proportions at a temperature where the component (D) decomposes, or by allowing the component (A), component (B), component (C), component (D) and component (E) to react in the above-mentioned proportions at a temperature where the component (D) decomposes, or the component (A), component (B), component (C), component (D), component (E) and component (F) to react in the above-mentioned proportions at a temperature where the component (D) decomposes. Upon allowing the components to react, the respective raw materials can be simultaneously mixed and allowed to react, but a method of mixing the component (A), component (B) and component (C), subsequently mixing the component (D), or the component (D) and component (E), and allowing the mixture to react, is preferred. In this case, other additives and the like may be simultaneously mixed with the component (A), component (B) and component (C), or may be simultaneously mixed with the component (D), or the component (D) and component (E).

It is also preferable that the components (D) and (E) are allowed to react, when mixed into the components (A), (B) and (C), in a state that the components (D) and (E) are sufficiently mixed thereinto.

To mix the component (A), component (B) and component (C), it is possible to employ a method of separately producing the component (A), component (B) and component (C), and blending the component (A), component (B) and component (C) in an extruder or the like; a method for solution blending by sufficiently dissolving the component (A), component (B) and component (C) in an appropriate solvent, for example, a saturated hydrocarbon such as heptane, hexane, decane, cyclohexane or the like, an aromatic hydrocarbon such as toluene, benzene, xylene or the like, or the like; a method of synthesizing the component (A), component (B) and component (C) in separate polymerization vessels, and blending the resulting polymers in another vessel; or the like.

To the mixture of the component (A), component (B) and component (C) thus obtained, the component (D), or the components (D) and (E) are directly added in succession and blended, and the blend is allowed to react at a temperature where the component (D) decomposes. When the reaction is performed at a temperature where the radical initiator (D) decomposes, a crosslinked heat resistant cyclic olefin resin composition having excellent heat resistance and moldability can be prepared.

The reaction can be performed in a state that the mixture of the raw materials has been melted, or in a solution state in which the mixture of the raw materials are dissolved in a solvent.

In the case of performing the reaction in a molten state, the mixture of the raw materials are melt kneaded using a kneading apparatus such as a mixing roll, a banburry mixer, an extruder, a kneader, a continuous mixer or the like, and allowed to react. The reaction can be performed at not lower than a one-minute half-life of the radical initiator (D), typically at 150 to 300°C, preferably 170 to 270°C, for typically 10 seconds to 30 minutes, and preferably 1 minute to 10 minutes.

In the case of performing the reaction in a solution state, as the solvent, the same solvents as those used for the above-described method for solvent blending can be used. The reaction can be performed at not lower than a one-minute half-life of the radical initiator (D), typically at 50°C to 300°C, for typically 10 seconds to 2 hours.

It is conceived that in the reaction described above, the organic peroxide as the radical initiator (D) decomposes, leading to a radical reaction, and the component (A) and the component (B) are partially crosslinked, consequently obtaining a reaction product having excellent heat resistance. Furthermore, in the case where the component (E) which is a radical polymerizable compound is present, crosslinking is further facilitated, and a reaction product which is excellent strength-wise is obtained. When the reaction product thus obtained is used directly, or after having the solvent removed by distillation or the like, a crosslinked heat resistant cyclic olefin resin composition is obtained.

<Substrate>

The cyclic olefin resin composition of the present invention can be used for a printed circuit board or a package board, by molding the resin composition into a sheet or film. Since the substrate obtained from the cyclic olefin resin composition of the present embodiment has excellent permittivity or dielectric tangent, the substrate can be suitably used as a substrate for high frequency circuit, even among the printed circuit boards. For the method of molding the resin composition into a sheet or film, various known methods such as injection molding, extrusion molding, press molding, casting and the like are applicable.

The method of forming a substrate for high frequency circuit of the invention using the resin composition of the invention is not particularly limited. For example, the substrate can be obtained by forming a sheet from the resin

composition, or adhering sheets made of the resin composition on both surfaces of a base material such as glass cross or the like interposed at the center. If necessary, the substrate may be fabricated into a laminate by multi-laminating such sheet, core material or the like together with metal foil according to a standard method. Also, the substrate may be obtained by laminating and integrating other known core material, film, prepreg, metal foil and the like according to a standard method. For example, more specifically, by using a configuration in which one sheet or plural sheets made of this resin composition are used, and metal foil such as electrolytic copper foil or the like is further stacked thereon, and hot pressing the configuration at a molding pressure of 1 to 15 $MPa/cm^2$ for a certain time, a laminate plate for high frequency circuit having excellent adhesiveness with metal foil, and having excellent heat resistance and dielectric properties can be produced. The temperature of this pressurized compression may depend on the combination of the metal foil and the sheet, or the like. However, since thermal fusibility of the sheet can be utilized, it is preferable to set the lamination pressing temperature at above the glass transition temperature of the sheet, in the range of 130 to 300°C. Furthermore, since press molding is performed for the purpose of bonding between sheets, between sheet and metal foil, or the like, and adjustment of the thickness of the laminate plate, the compressing conditions can be selected according to necessity.

For the conductor metal, metals such as copper, aluminum, nickel, gold, silver, stainless steel and the like can be used. For the method of forming a conductor layer, the conductor layer can be produced by, in addition to the method of thermally fusing the metals, a method of adhering using an adhesive, or a method of laminating by means of spattering, vapor deposition, plating or the like. As the adhesive that can be used for adhesion of the resin composition layer and the conductor layer when forming a laminate plate for high frequency circuit of the invention, known heat resistant adhesives such as epoxy, polyimide and the like can be used. However, in order to the adhesive does not affect the dielectric properties of the insulating layer, the ratio of the thickness of the layer made of the resin composition of the invention/the layer thickness of the adhesive is preferably 2 or greater, and more preferably 3 or greater. Formation of a circuit can be carried out by a variety of known lithographic methods, for example, by an etching method and the like. The form of the laminate plate may be either a one-sided plate or a double-sided plate, and there is no limit on the number of laminates, but it is preferable that about 2 layers to 30 layers are laminated.

[EXAMPLES]

The present invention will be described hereinbelow in detail with reference to Examples, but the invention is not intended to be limited by these Examples. According to the invention, the respective properties were measured by the following methods.

(Permittivity and dielectric tangent)

The permittivity (ε) and dielectric tangent (tanδ) at 25°C and 12 GHz were measured by a cavity resonator method. With regard to the dielectric properties, an ε of 2.5 or less, a tanδ of 0.001 or less, and $\sqrt{\varepsilon} \times \tan\delta$ of 1.53E-03 or less were judged to be practically acceptable.

(Water absorption rate)

According to the method of JIS K7209, a specimen having a size of 40 mm × 20 mm × 2 mm in thickness was used and immersed in distilled water at 23°C for 48 hours. The water absorption rate was calculated by measuring the weight change of the specimen before and after the immersion. A water absorption rate of less than 0.1% was judged to be practically acceptable.

(Reflow heat resistance)

According to the method of JIS C6481, a specimen having a size of 10 mm x 30 mm x 1 mm in thickness was bonded with copper foil on the surface and the rear surface by press molding, thus to produce a copper clad laminate specimen having partially copper foil-removed surfaces (side surfaces of the specimen). This was pretreated at 105°C for 75 minutes, and then was humidity conditioned by immersing in boiling water for 1 hour. Using an infrared-hot air combined type reflow soldering apparatus (Nippon Antom Co., Ltd., SOLSYS-2001R), a reflow process was carried out with a temperature profile of 60 seconds of temperature rise → 90 seconds of maintaining at 175°C → 50 seconds of temperature rise → 30 seconds of maintaining at 260°C → cooling, and it was evaluated as to whether there was any change in the external appearance and shape of the specimen.

The criteria of evaluation for the deformation of the specimen and the degree of flow of the resin component in the specimen were as follows.

Deformation

It was judged by naked eyes, and a result of level 4 or higher was judged to be practically acceptable.

Scale

Level 5: No deformation
Level 4: Minimal deformation
Level 3: Presence of deformation
Level 2: Presence of deformation, and the surface irregularities are recognized to be slightly like fish-eyes. Slight peeling-off of copper foil also recognized.

Level 1: Significantly large deformation, and large surface irregularities recognized. Peeling-off of copper foil also recognized.

Resin flow

The degree of the resin component flowing out from the copper foil-removed surface (side surface of the specimen) was judged by naked eyes. A result of level 4 or higher was judged to be practically acceptable.

Scale

Level 5: No resin flowing out
Level 4: Resin flowing out to a negligible extent
Level 3: Presence of resin flowing out
Level 2: Resin flowing out from the copper foil-removed surface (side surface of the specimen), and partially expanded with foaming

Level 1: Resin flowing out from the copper foil-removed surface (side surface of the specimen), and partially expanded with foaming. Peeling-off of copper foil recognized.

(Tensile elongation)

According to ASTM D638, tensile elongation was measured at a testing rate of 50 mm/min.

(Adhesiveness)

According to the method of JIS C6481, a specimen having a size of 25 mm $\times$ 75 mm $\times$ 1 mm in thickness was bonded with copper foil on the surface and the rear surface by press molding, thus to produce a copper clad laminate specimen having partially copper foil-removed surfaces (side surfaces of the specimen). This was used to evaluate the peeling strength of the copper foil. A peeling strength of the copper foil of not less than 0.8 kN/m was judged to be practically acceptable.

[EXAMPLE b-1]

50% by weight of an ethylene-tetracyclododecene copolymer (A) (copolymerization ratio (molar basis): ethylene/tetracyclododecene = 60/40) having a glass transition temperature of 145°C and an MFR of 7 g/10 min (260°C, 2.16 kg), 25% by weight of an ethylene-propylene copolymer (B) having an MFR of 0.4 g/10 min (230°C, 2.16 kg), an ethylene content of 80 mol%, and a density of 867 mg/m$^3$, and 25% by weight of a modified polyolefin (maleic anhydride-modified ethylene·propylene copolymer) (C) having an MFR of 2.6 g/10 min (temperature: 190°C, load 2.16 kg) and a density of 880 kg/m$^3$ were mixed. Then, the mixture was melt mixed using a twin screw extruder (Ikegai Iron Works, Ltd., PCM-45) at a cylinder temperature of 250°C, a die temperature 250°C and a speed of screw rotation of 100 rpm, and was pelletized with a pelletizer. 0.1 parts by weight of an organic peroxide (Perhexyne 25B: Nippon Oil and Fats Co., Ltd.) as the component (D) and 0.1 parts by weight of divinylbenzene as the component (E), based on 100 parts by weight

of the obtained pellets ((A)+(B)+(C)), were added and sufficiently mixed. A melt reaction was performed with this mixture using the above-described twin screw extruder at a cylinder temperature of 250°C, a die temperature of 250°C, and a speed of screw rotation of 80 rpm. Finally, the product was pelletized with a pelletizer.

Using the obtained pellets, a sheet having a thickness of 1 mm was fabricated by press molding for the evaluation of dielectric properties, reflow heat resistance and copper foil peeling strength, and a sheet having a thickness of 2 mm was fabricated by injection molding for the evaluation of water absorption rate. The obtained sheets were used in the evaluation of dielectric properties, water absorption rate, reflow heat resistance, adhesiveness and tensile elongation. The results are presented in Table 2.

[EXAMPLE b-2]

Molding was performed in the same manner as in Example b-1, except that 70% by weight of the ethylene·tetracyclododecene copolymer (A), 15% by weight of an ethylene·butene copolymer (B) having an MFR of 0.5 g/10 min (temperature 190°C, load 2.16 kg), a density of 885 kg/$m^3$, and an ethylene content of 90 mol%, and 15% by weight of a modified polyolefin (maleic anhydride-modified ethylene·butene copolymer) (C) having an MFR of 3.0 g/10 min, and a density of 893 kg/$m^3$ were used, and 0.1 parts by weight of an organic peroxide (Perhexyne 25B: Nippon Oil and Fats Co., Ltd.) as the component (D), and 0.1 parts by weight of divinylbenzene as the component (E), based on 100 parts by weight of ((A)+(B)+(C)), were used. The obtained sheets were used in the evaluation of dielectric properties, water absorption rate, reflow heat resistance and adhesiveness. The results are presented in Table 2.

[EXAMPLE b-3]

Molding was performed in the same manner as in Example 1, except that 50% by weight of the ethylene·tetracyclododecene copolymer (A) and 25% by weight of the ethylene·propylene copolymer (B), and 25% by weight of the same modified polyolefin (C) as that of Example b-1 were used, and 0.1 parts by weight of an organic peroxide (Perhexyne 25B: Nippon Oil and Fats Co., Ltd.) as the component (D), and 0.1 parts by weight of divinylbenzene as the component (E), based on 100 parts by weight of ((A)+(B)+(C)), were used, and the resulting product was pelletized in the same manner as in Example b-1. 400 parts by weight of an electroconductive inorganic filler (F), based on 100 parts by weight of the resulting pellets, was used and melt kneaded with the pellets in a Laboplast mill apparatus at a temperature of 250°C and a speed of screw rotation of 50 rpm. The resulting sheets were used in the evaluation of the dielectric properties, water absorption rate, reflow heat resistance and adhesiveness. The results are presented in Table 2.

[EXAMPLE b-4]

Molding was performed in the same manner as in Example b-1, except that 50% by weight of a hydrogenation product of a ring-opening polymer of dicyclopentadiene (Zeonor 1020R (product name, Zeon Corp. in Japan)) (A) having a glass transition temperature of 105°C and an MFR of 20 g/10min (280°C, 2.16 kg) was used instead of the ethylene·tetracyclododecene copolymer (A). The obtained sheets were used in the evaluation of the dielectric properties, water absorption rate, reflow heat resistance, adhesiveness and tensile elongation. The results are presented in Table 2.

[EXAMPLE b-5]

Molding was performed in the same manner as in Example b-1, except that 50% by weight of the ethylene·tetracyclododecene copolymer (A) having a glass transition temperature of 145°C and an MFR of 7 g/10 min (260°C, 2.16 kg), and 50% by weight of the ethylene·propylene copolymer (B), and 0.1 parts by weight of an organic peroxide (Perhexyne 25B: Nippon Oil and Fats Co., Ltd.) as the component (D) and 0.1 parts by weight of divinylbenzene as the component (E), based on 100 parts by weight of ((A)+(B)), were used, while the modified polyolefin (C) was not used. The resulting sheets were used in the evaluation of the dielectric properties, water absorption rate, reflow heat resistance and adhesiveness. The results are presented in Table 2.

[EXAMPLE b-6]

Molding was performed in the same manner as in Example b-1, except that 80% by weight of the ethylene·tetracyclododecene copolymer (A) having a glass transition temperature of 145°C and an MFR of 7 g/10 min (260°C, 2.16 kg) and 20% by weight of the ethylene·propylene copolymer (B), and also 0.1 parts by weight of an organic peroxide (Perhexyne 25B: Nippon Oil and Fats Co., Ltd.) as the component (D) and 0.05 parts by weight of divinylbenzene as the component (E), based on 100 parts by weight of ((A)+(B)), were used, while the modified polyolefin (C) was not used. The resulting sheets were used in the evaluation of the dielectric properties, water absorption rate, reflow heat

resistance and adhesiveness. The results are presented in Table 2.

[EXAMPLE b-7]

Molding was performed in the same manner as in Example b-1, except that 40% by weight of the ethylene·tetracyclododecene copolymer (A) having a glass transition temperature of 145°C and an MFR of 7 g/10 min (260°C, 2.16 kg) and 60% by weight of the ethylene·propylene copolymer (B), and also 0.1 parts by weight of an organic peroxide (Perhexyne 25B: Nippon Oil and Fats Co., Ltd.) as the component (D) and 0.1 parts by weight of divinylbenzene as the component (E), based on 100 parts by weight of ((A)+(B)), were used, while the modified polyolefin (C) was not used. The resulting sheets were used in the evaluation of the dielectric properties, water absorption rate, reflow heat resistance and adhesiveness. The results are presented in Table 1.

(Table 1)

| | | Example b-1 | Example b-2 | Example b-3 | Example b-4 | Example b-5 * | Example b-6* | Example b-7* |
|---|---|---|---|---|---|---|---|---|
| Component (A) | Type | Ethylene-tetracyclododecene copolymer | Ethylene-tetracyclododecene copolymer | Ethylene-tetracyclododecene copolymer | Hydrogenation product of ring-opening polymer of dicyclopentadiene | Ethylene-tetracyclododecene copolymer | Ethylene-tetracyclododecene copolymer | Ethylene-tetracyclocodecene copolymer |
| | Tg: °C | 145 | 145 | 145 | 105 | 145 | 145 | 145 |
| | MFR:g/10 min (260°C·2.16kg) | 7 | 7 | 7 | 20(280°C) | 7 | 7 | 7 |
| Component (B) | Type | Ethylene-propylene copolymer | Ethylene-butene copolymer | Ethylene-propylene copolymer | Ethylene-propylene copolymer | Ethylene·propylene copolymer | Ethylene·propylene copolymer | Ethylene·propylene copolymer |
| | Composition: mol% | Ethylene content a 80 mol% | Ethylene content = 90 mol% | Ethylene content = 80 mol% | Ethylene content = 80 mol% | Ethylene content = 80 mol% | Ethylene content = 80 mol% | Ethylene content = 00 mol% |
| | Density: $kg/m^2$ | 867 | 885 | 867 | 867 | 867 | 867 | 867 |
| | MFR:g/10 (2.16kg) min | 0.4(230°C) | 0.5(190°C) | 0.4(230°C) | 0.4(230°C) | 0.4(230°C) | 0.4(230°C) | 0.4(230°C) |
| Component (C) | Density: $kg/m^3$ | 890 | 893 | 860 | 880 | - | - | - |
| | MFR:g/10 min 190°C·2.16kg) | 2.6 | 3.0 | 2.6 | 2.6 | - | - | - |
| (A)/(B)/(C) | Wt% | 50/25/25 | 70/15/15 | 50/25/25 | 50/25/25 | 50/50/0 | 00/20/0 | 40/60/0 |

(continued)

| | | Example b-1 | Example b-2 | Example b-3 | Example b-4 | Example b-5 * | Example b-6* | Example b-7* |
|---|---|---|---|---|---|---|---|---|
| Component (D) | Parts by weight | 0.1 | 0.1 | 0.1 | 0.1 | 0.1 | 0.1 | 0.1 |
| Component (E) | Parts by weight | 0.1 | 0.1 | 0.1 | 0.1 | 0.1 | 0.05 | 0.1 |
| Component (F) | Parts by weight | - | - | 400 | - | - | - | - |
| Dielectric properties (1.2 GHz) | t | 2.31 | 2.32 | 2.29 | 2.22 | 2.31 | 2.29 | 2.30 |
| | tanδ | 0.00074 | 0.00064 | 0.00098 | 0.00870 | 0.00050 | 0.00080 | 0.00064 |
| | √extanδ | 1.126.-03 | 9.75E-04 | 1.48E-02 | 1.30E-03 | 7.60E-04 | 1.21E-03 | 9.71E-04 |
| Water absorption rate | % | 0.01 | 0.01 | 0.01 | 0.01 | 0.01 | 0.01 | 0.01 |
| Reflow heat resistance (260° C·30sec) | Deformation | Level 5 | Level 5 | Level 5 | Level 4 | Level 5 | Level 4 | Level 5 |
| | Resin flow | Level 5 | Level 5 | Level 5 | Level 4 | Level 5 | Level 4 | Level 5 |
| Adhesiveness | 1:N/m | 1.09 | 0.94 | 0.90 | 1.02 | 0.11 | 0.10 | 0.21 |
| Tensile elongation | % | 34 | | | 83 | | | |

* Comparative

The cyclic olefin resin compositions of Examples b-1 to b-7 were recognized to be excellent in any of the dielectric properties, water absorption rate and reflow heat resistance. Furthermore, the cyclic olefin resin compositions of Examples b-1 to b-4 containing the modified polyolefin (C) were recognized to be also excellent in adhesiveness.

In Example b-5, the ethylene·tetracyclododecene copolymer (A) was modified with maleic acid so as to obtain an adhesiveness that is equal to that of Examples b-1 to b-4. However, the sheets obtained from the resin composition showed yellowing, and also had deteriorated heat resistance.

Furthermore, the pellets obtained in Example b-1 were used to produce a resin film in the manner described below , and a laminate comprising the resin film and E glass cross was obtained.

The pellets were used to produce a resin film having a width of 600 mm and a thickness of 40 μm in a T-die molding machine of a single screw extruder with 50 mmϕ, at a cylinder temperature and a die temperature of 260°C, respectively.

Subsequently, a laminate was obtained by alternately laminating the resin film and an E glass cross, so that the outermost layers would comprise the resin film.

With regard to this laminate, in the case of using two sheets of E glass cross, an E glass cross having a thickness of 90 μm was used. The centrally disposed layer comprising resin film was formed by stacking 4 sheets of the resin film having a thickness of 40 μm, while other layers comprising resin film was formed by stacking 8 sheets of the resin film having a thickness of 40 μm. Also, in the case of using 8 sheets of E glass cross, an E glass cross having a thickness of 60 μm was used. The layer comprising resin film was formed by stacking 10 sheets of the resin film having a thickness of 40 μm.

Next, copper foil having a thickness of 100 μm was stacked on both sides of the outermost layers (resin film layer) of the laminate obtained in the above, so that the matt surface would be a resin film layer. Then, a polyimide film was stacked as a mold releasing film, and then the laminate was inserted between two sheets of metal plates made of stainless steel and hot pressed using a mini test press (Toyo Seiki Kogyo Co., Ltd.), at a temperature of 300°C and a pressure of 3 MPa for 12 minutes. Thereby, a double-sided·copper clad laminate having a thickness of about 0.8 mm was obtained.

A specimen cut from the double-sided copper clad laminate obtained in the same manner as in Example A was used to perform a solder heat resistance test at 260°C according to JIS C6481. As a result, the double-sided copper clad laminate did not undergo deformation, and the solder heat resistance was good.

The cyclic olefin resin composition of the present invention can provide a substrate having excellent dielectric properties, low water absorbability and excellent heat resistance. This substrate is particularly excellent in the dielectric properties in the high frequency region, and can be used as a substrate for high frequency circuit which is suitable for high frequency signal transmission and the like.

## Claims

1. A cyclic olefin resin composition comprising:

    (A) 35 to 85 parts by weight of a cyclic olefin polymer having a glass transition temperature of 60 to 200°C;
    (B) 10 to 60 parts by weight of a flexible copolymer produced by polymerizing at least two or more monomers selected from the group consisting of an olefin compound, a diene compound and an aromatic vinyl hydrocarbon compound, and having a glass transition temperature of 0°C or lower; and
    (C) 5 to 55 parts by weight of a modified polyolefin which is a polyolefin having a polar group ;
    and further comprising, based on 100 parts by weight of the components (A), (B) and (C):
    (D) 0.01 to 5 parts by weight of a radical initiator; and
    (E) 0 to 5 parts by weight of a polyfunctional compound having two or more radical polymerizable functional groups in the molecule.

2. A cyclic olefin resin composition according to claim 1, wherein the radical initiator (D) is an organic peroxide.

3. A cyclic olefin resin composition according to claim 1, wherein
    the cyclic olefin polymer (A) is a cyclic olefin polymer having one or two or more structures represented by the following General Formula (1):

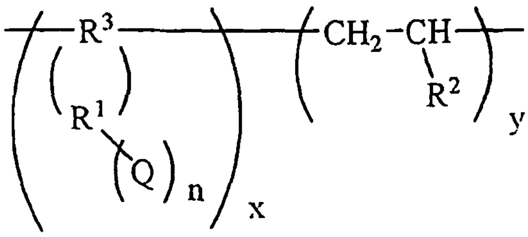

(1)

wherein x and y represent copolymerization ratios, and are real numbers satisfying the relationship: $0/100 \leq y/x \leq 95/5$, while x and y are on the molar basis;

n represents the number of substitution for substituent Q, and is an integer of $0 \leq n \leq 2$;

$R^1$ is a group having a valence of (2+n), selected from the group consisting of hydrocarbon groups having 2 to 20 carbon atoms, while $R^1$, which is present in plurality, may be identical or different;

$R^2$ is a hydrogen atom, or a monovalent group selected from the group consisting of hydrocarbon groups which are composed of carbon and hydrogen, and have 1 to 10 carbon atoms, while $R^2$, which is present in plurality, may be identical or different;

$R^3$ is a tetravalent group selected from the group consisting of hydrocarbon groups having 2 to 10 carbon atoms, while $R^3$, which is present in plurality, may be identical or different; and

Q represents $COOR^4$ (wherein $R^4$ is a hydrogen atom or a monovalent group selected from the group consisting of hydrocarbon groups which are composed of carbon and hydrogen, and have 1 to 10 carbon atoms), while Q, which is present in plurality, may be identical or different.

**4.** A cyclic olefin resin composition according to claim 1, wherein the cyclic olefin polymer (A) is a ring-opening polymer of a cyclic olefin, or a hydrogenation product thereof.

**5.** A cyclic olefin resin composition according to claim 1, wherein the cyclic olefin polymer (A) is a cyclic olefin polymer having one or two or more structures represented by the following General Formula (2):

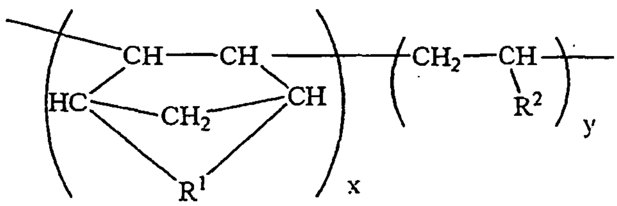

(2)

wherein $R^1$ is a group having a valence of (2+n), selected from the group consisting of hydrocarbon groups having 2 to 20 carbon atoms, while $R^1$, which is present in plurality, may be identical or different;

$R^2$ is hydrogen, or a monovalent group selected from the group consisting of hydrocarbon groups having 1 to 5 carbon atoms, while $R^2$, which is present in plurality, may be identical or different; and

x and y represent copolymerization ratios, and are real numbers satisfying the relationship: $5/95 \leq y/x \leq 95/5$, while x and y are on the molar basis.

**6.** A cyclic olefin resin composition according to claim 1, wherein the cyclic olefin polymer (A) is a copolymer of ethylene and tetracyclo[4.4.0.$1^{2,5}$.$1^{7,10}$]-3-dodecene.

**7.** A cyclic olefin resin composition according to claim 2, wherein the composition is obtained by reacting the components (D) and (E) with the components (A), (B) and (C).

**8.** A cyclic olefin resin composition according to claim 1, wherein the composition further comprises (F) 0 to 600 parts by weight of an inorganic filler, based on 100 parts by weight of the total amount of the components (A), (B), (C), (D) and (E).

**9.** A substrate for a printed circuit board obtainable by molding the cyclic olefin resin composition according to any one

of claims 1 to 8.

**10.** A substrate for high frequency circuit, formed from the substrate according to claim 9.

**11.** Use of a substrate according to claim 10 as a substrate for a high frequency circuit.

**Patentansprüche**

**1.** Zyklische Olefinharz-Zusammensetzung umfassend:

(A) 35 bis 85 Gewichtsanteile eines zyklischen Olefinpolymers, das eine Glasübergangstemperatur von 60 bis 200°C aufweist;
(B) 10 bis 60 Gewichtsanteile eines flexiblen Copolymers, das durch Polymerisation von mindestens zwei oder mehreren Monomeren hergestellt wurde, die aus der Gruppe ausgesucht wurden, die aus einer Olefinverbindung, einer Dienverbindung und einer aromatischen Vinylkohlenwasserstoffverbindung besteht, und eine Glasübergangstemperatur von 0°C oder niedriger aufweist; und
(C) 5 bis 55 Gewichtsanteile eines modifizierten Polyolefins, das ein Polyolefin mit einer polaren Gruppe ist; und weiterhin umfassend, bezogen auf 100 Gewichtsanteile der Komponenten (A), (B) und (C):
(D) 0,01 bis 5 Gewichtsanteile eines Radikalinitiators; und
(E) 0 bis 5 Gewichtsanteile einer polyfunktionellen Verbindung die zwei oder mehr radikalisch polymerisierbare funktionelle Gruppen in dem Molekül aufweist.

**2.** Zyklische Olefinharz-Zusammensetzung nach Anspruch 1, wobei der Radikalinitiator (D) ein organisches Peroxid ist.

**3.** Zyklische Olefinharz-Zusammensetzung nach Anspruch 1, wobei das zyklische Olefinpolymer (A) ein zyklisches Olefinpolymer ist, das zwei oder mehrere Strukturen aufweist, die der allgemeine folgende Formel (1) entsprechen:

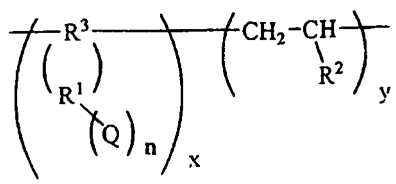

(1)

wobei x und y Copolymerisationsverhältnissen entsprechen und reelle Zahlen sind, die der Beziehung genügen: $0/100 \leq y/x \leq 95/5$, während x und y in Mol angegeben sind; n entspricht der Zahl der Substituenten für Substituent Q und ist eine ganze Zahl aus $0 \leq n \leq 2$;
$R^1$ ist ein Rest der eine Valenz von (2+n) aufweist, ausgesucht aus der Gruppe, die aus Kohlenwasserstoffresten mit zwei bis 20 Kohlenstoffatomen besteht, während $R^1$, das mehrmals vorhanden ist, identisch oder unterschiedlich sein kann;
$R^2$ ist ein Wasserstoffatom, oder ein monovalenter Rest ausgesucht aus der Gruppe, die aus Kohlenwasserstoffresten besteht, die aus Kohlenstoff und Wasserstoff aufgebaut sind, und 1 bis 10 Kohlenstoffatome aufweisen, während $R^2$, das mehrmals vorhanden ist, identisch oder unterschiedlich sein kann;
$R^3$ ist ein tetravalenter Rest, ausgesucht aus der Gruppe, die aus Kohlenwasserstoffresten mit 2 bis 10 Kohlenstoffatomen besteht, während $R^3$, das mehrmals vorhanden ist, identisch oder unterschiedlich sein kann; und
Q entspricht $COOR^4$ (wobei $R^4$ ein Wasserstoffatom oder ein monovalenter Rest ausgesucht aus der Gruppe, die aus Kohlenwasserstoffresten besteht, die aus Kohlenstoff und Wasserstoff aufgebaut sind und 1 bis 10 Kohlenstoffatome aufweisen), während Q, das mehrmals vorhanden ist, identisch oder unterschiedlich sein kann.

**4.** Zyklische Olefinharz-Zusammensetzung nach Anspruch 1, wobei das zyklische Olefinpolymer (A) ein durch Ringöffnungspolymerisation hergestelltes Polymer eines zyklischen Olefins oder ein hydriertes Produkt davon ist.

**5.** Zyklische Olefinharz-Zusammensetzung nach Anspruch 1, wobei das zyklische Olefinpolymer (A) ein zyklisches Olefinpolymer ist, das ein oder zwei oder mehrere Strukturen aufweist, die der folgenden allgemeinen Formel (2)

entsprechen:

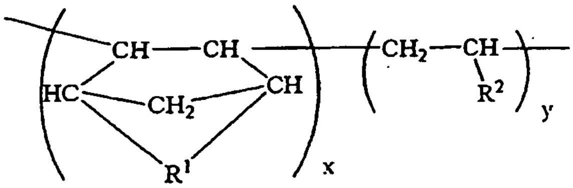

(2)

wobei $R^1$ ein Rest ist, der eine Valenz von (2+n) aufweist, ausgesucht aus der Gruppe bestehend aus Kohlenwasserstoffresten mit 2 bis 20 Kohlenstoffatomen, während $R^1$, das mehrmals vorhanden ist, identisch oder unterschiedlich sein kann;
$R^2$ Wasserstoff oder ein monovalenter Rest ist, ausgesucht aus der Gruppe, die aus Kohlenwasserstoffresten mit 1 bis 5 Kohlenstoffatomen besteht, während $R^2$, das mehrmals vorhanden ist, identisch oder unterschiedlich sein kann; und
x und y Copolymerisationsverhältnissen entsprechen und reelle Zahlen sind, die der Beziehung genügen: $5/95 \leq y/x \leq 95/5$, während x und y in Mol angegeben sind.

6. Zyklische Olefinharz-Zusammensetzung nach Anspruch 1, wobei das zyklische Olefinpolymer (A) ein Copolymer aus Ethylen und Tetracyclo[4.4.0.$1^{2,5}$.$1^{7,10}$]-3-dodecen ist.

7. Zyklische Olefinharz-Zusammensetzung nach Anspruch 1, wobei die Zusammensetzung durch Reagieren lassen der Komponenten (D) und (E) mit den Komponenten (A), (B) und (C) erhalten wird.

8. Zyklische Olefinharz-Zusammensetzung nach Anspruch 1, wobei die Zusammensetzung weiter umfasst (F) 0 bis 600 Gewichtsanteile eines anorganischen Füllstoffes, bezogen auf 100 Gewichtsanteile der Komponenten (A), (B), (C), (D) und (E).

9. Substrat für eine bedruckte Leiterplatte, erhältlich durch Schmelzen der zyklischen Olefinharz-Zusammensetzung nach irgendeinem der Ansprüche 1 bis 8.

10. Substrat für Hochfrequenzschaltungen, gebildet aus dem Substrat nach Anspruch 9.

11. Verwendung eines Substrats nach Anspruch 10 als ein Substrat für eine Hochfrequenzschaltung.

**Revendications**

1. Composition de résine d’oléfine cyclique comprenant :

   (A) 35 à 85 parties en poids d’un polymère d’oléfine cyclique dont la température de transition vitreuse est de 60 à 200 °C ;
   (B) 10 à 60 parties en poids d’un copolymère souple produit par polymérisation d’au moins deux monomères choisis dans l’ensemble consistant en un composé d’oléfine, un composé diénique et composé hydrocarboné vinylique aromatique et dont la température de transition vitreuse est inférieure ou égale à 0 °C ; et
   (C) 5 à 55 parties en poids d’une polyoléfine modifiée qui est une polyoléfine contenant un groupe polaire ;
   et comprenant en outre, rapporté à 100 parties en poids des composants (A), (B) et (C) :
   (D) 0,01 à 5 parties en poids d’un initiateur de radicaux ; et
   (E) 0 à 5 parties en poids d’un composé polyfonctionnel contenant deux groupes fonctionnels polymérisables par les radicaux dans la molécule.

2. Composition de résine d’oléfine cyclique selon la revendication 1, dans laquelle l’initiateur de radicaux (D) est un peroxyde organique.

**3.** Composition de résine d'oléfine cyclique selon la revendication 1, dans laquelle le polymère d'oléfine cyclique (A) est un polymère d'oléfine cyclique contenant une ou plusieurs structures représentées par la formule générale suivante (1) :

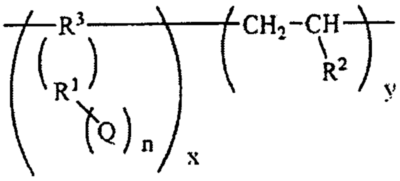

(1)

dans laquelle x et y représentent des rapports de copolymérisation, et sont des nombres réels respectant la relation suivante : $0/100 \leq y/x \leq 95/5$, sur une base molaire ;
n représente le nombre de substitutions pour le substituant Q, et est un nombre entier tel que $0 \leq n \leq 2$;
$R^1$ représente un groupe ayant une valence de (2+n), choisi dans l'ensemble consistant en groupes hydrocarbonés contenant 2 à 20 atomes de carbone, les groupes $R^1$, dont plusieurs sont présents, pouvant être identiques ou différents ;
$R^2$ représente un atome d'hydrogène, ou un groupe monovalent choisi dans l'ensemble consistant en groupes hydrocarbonés qui sont composés d'atomes de carbone et d'hydrogène, et contiennent 1 à 10 atomes de carbone, les groupes $R^2$, dont plusieurs sont présents, pouvant être identiques ou différents ;
$R^3$ représente un groupe tétravalent choisi dans l'ensemble consistant en groupes hydrocarbonés contenant 2 à 10 atomes de carbone, les groupes $R^3$, dont plusieurs sont présents, pouvant être identiques ou différents ; et
Q représente $COOR^4$ ($R^4$ représentant un atome d'hydrogène ou un groupe monovalent choisi dans l'ensemble consistant en groupes hydrocarbonés qui sont composés d'atomes de carbone et d'hydrogène, et contiennent 1 à 10 atomes de carbone), les groupes Q, dont plusieurs sont présents, pouvant être identiques ou différents.

**4.** Composition de résine d'oléfine cyclique selon la revendication 1, dans laquelle le polymère d'oléfine cyclique (A) est un polymère polymérisé par ouverture de cycle d'une oléfine cyclique, ou l'un de ses produits d'hydrogénation.

**5.** Composition de résine d'oléfine cyclique selon la revendication 1, dans laquelle le polymère d'oléfine cyclique (A) est un polymère d'oléfine cyclique contenant une ou plusieurs structures représentées par la formule générale (2) suivante :

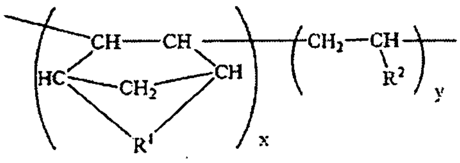

(2)

dans laquelle $R^1$ représente un groupe ayant une valence de (2+n), choisi dans l'ensemble consistant en groupes hydrocarbonés contenant 2 à 20 atomes de carbone, les groupes $R^1$, dont plusieurs sont présents, pouvant être identiques ou différents ;
$R^2$ représente un atome d'hydrogène, ou un groupe monovalent choisi dans l'ensemble consistant en groupes hydrocarbonés contenant 1 à 5 atomes de carbone, les groupes $R^2$, dont plusieurs sont présents, pouvant être identiques ou différents ; et
x et y représentent des rapports de copolymérisation, et sont des nombres réels respectant la relation suivante : $5/95 \leq y/x \leq 95/5$, sur une base molaire.

**6.** Composition de résine d'oléfine cyclique selon la revendication 1, dans laquelle le polymère d'oléfine cyclique (A) est un copolymère d'éthylène et de tétracyclo[4.4.0.$1^{2,5}$.$1^{7,10}$]-3-dodécène.

**7.** Composition de résine d'oléfine cyclique selon la revendication 1, la composition étant obtenue en faisant réagir les composants (D) et (E) avec les composants (A), (B) et (C).

**8.** Composition de résine d'oléfine cyclique selon la revendication 1, la composition comprenant en outre (F) 0 à 600 parties en poids d'une charge inorganique, rapporté à 100 parties en poids de la quantité totale des composants (A), (B), (C), (D) et (E).

**9.** Substrat pour carte de circuit imprimé pouvant être obtenu par moulage de la composition de résine d'oléfine cyclique selon l'une quelconque des revendications 1 à 8.

**10.** Substrat pour circuit haute fréquence, formé à partir du substrat selon la revendication 9.

**11.** Utilisation d'un substrat selon la revendication 10 comme substrat pour un circuit haute fréquence.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 50132099 A
- JP 62029191 A
- JP 1081390 A
- JP 7145213 A
- JP 61221206 A
- JP 64000106 A
- JP 2173112 A
- JP 60168708 A
- JP 61120816 A
- JP 61115912 A
- JP 61115916 A
- JP 61271308 A
- JP 61272216 A
- JP 62252406 A
- JP 62252407 A


### Non-patent literature cited in the description


- Polymeric Materials for High Frequency Applications. CMC Publishing, Inc, 1999
- **J.H. Gary ; G.E. Handwerk.** *Petroleum Refining Technology and Economics,* 1975, 74
- *Journal of Chemical Engineering of Japan,* 1994, vol. 27 (3), 310